# EUROPEAN PATENT SPECIFICATION

(11) **EP 4 436 373 B1**
(45) Date of publication and mention of the grant of the patent: **15.10.2025**
(21) Application number: 22822021.6
(22) Date of filing: 23.11.2022
(51) Int. Cl.: A01M 7/00, A01M 9/00, A01D 75/20, A01M 31/00, A01B 79/00

(54) **AGRICULTURAL SYSTEM FOR PROTECTING AN ANIMAL SPECIES**
LANDWIRTSCHAFTLICHES SYSTEM ZUM SCHUTZ EINER TIERART
SYSTÈME AGRICOLE POUR LA PROTECTION D'UNE ESPÈCE ANIMALE

(30) Priority: 23.11.2021 EP 21210037
(43) Date of publication of application: 02.10.2024
(73) Proprietor: BASF SE, 67056 Ludwigshafen am Rhein (DE)
(72) Inventor: GEBLER, Sebastian Thomas, 67117 Limburgerhof (DE); WELTJE, Lennart, 67117 Limburgerhof (DE); DENYS, Jeff, MISSISSAUGA, Ontario L4W 0B6 (CA); BRAUN, Joerg, 67117 Limburgerhof (DE)
(74) Representative: BASF IP Association
(86) International application number: PCT/EP2022/083041
(87) International publication number: WO 2023/094484

(56) References cited:
- US-B2- 9 743 655
- LENHARDT PATRICK P. ET AL: "Temporal coincidence of amphibian migration and pesticide applications on arable fields in spring", BASIC AND APPLIED ECOLOGY, vol. 16, no. 1, 1 February 2015 (2015-02-01), AMSTERDAM, NL, pages 54 - 63, XP055929721, ISSN: 1439-1791, DOI: 10.1016/j.baae.2014.10.005
- BRÜHL CARSTEN A. ET AL: "Terrestrial pesticide exposure of amphibians: An underestimated cause of global decline?", vol. 3, no. 1, 1 December 2013 (2013-12-01), XP055929711, Retrieved from the Internet <URL:https://www.nature.com/articles/srep01135.pdf> [retrieved on 20220610], DOI: 10.1038/srep01135
- ALDRICH ANNETTE ET AL: "Amphibians and plant-protection products: what research and action is needed?", ENVIRONMENTAL SCIENCES EUROPE, SPRINGER BERLIN HEIDELBERG, BERLIN/HEIDELBERG, vol. 28, no. 1, 17 May 2016 (2016-05-17), pages 1 - 8, XP035687572, ISSN: 2190-4707, [retrieved on 20160517], DOI: 10.1186/S12302-016-0085-6

## Description

### FIELD OF THE INVENTION

The present invention relates to an agricultural system for protecting an animal species, a method for protecting the animal species, and a corresponding computer program product for protecting the animal species.

### BACKGROUND OF THE INVENTION

It is known that some animal species, such as amphibians and particularly their metamorphs, might be negatively affected by certain chemical products that are regularly applied in agricultural zones such as crop fields. Such chemical products include certain fertilizers and plant protection products, e.g., fungicides or insecticides, which support growth, yield and quality of the crop. Applying these chemical products in certain animal protection zones, e.g., the surroundings of water bodies, is often limited by law to protect certain animal species present in these animal protection zones. Furthermore, a potential negative impact to wild animals should be limited as much as reasonably possible when performing agricultural processing comprising seeding, fertilizing, applying plant protection products, harvesting, or any other agricultural processing in the fields.

For example, CH 701 643 A2 discloses a method and device for detecting animals including their spawn hidden in agriculturally used fields and grassland. Animals are searched in two independent phases. A first phase is associated to the breeding season and independent of agricultural processing. In the first phase, an entire area is searched for animals at the beginning of the breeding season using a detection method and detected young animals are marked with signal-providing technical devices for detecting them over larger distances. The second phase is associated with the agricultural processing and is performed shortly before agricultural processing is performed in the fields. In the second phase, receiver devices are used for detecting the marked animals in order to remove them from the fields to allow unobstructed performing of agricultural processing.

A further agricultural system and method for protecting an animal species present in an animal protection zone by determining a safe time window for an agricultural processing in an agricultural zone is known from US 9 743 655 B2.

### SUMMARY OF THE INVENTION

It can be seen as an object of the present invention to provide an agricultural system for protecting an animal species, which allows protecting the animal species while performing agricultural processing.

In a first aspect of the present invention, an agricultural system for protecting an animal species present in an animal protection zone is presented. The agricultural system is configured for
- obtaining or generating agricultural zone data indicative of an agricultural zone in which agricultural processing is planned,
- obtaining or generating protection zone data indicative of the animal protection zone that is associated with the animal species present therein,
- providing an animal life-cycle model which is configured for simulating a life-cycle of the animal species,
- determining a life stage of the animal species based on the animal life-cycle model,
- determining an animal protection time window based on the life stage of the animal species during which no agricultural processing which may affect, in particular, negatively affect, the animal species is to be performed in the animal protection zone in order to protect the animal species,
- determining an overlap zone as a spatial overlap between the agricultural zone and the animal protection zone based on the agricultural zone data and protection zone data, and
- determining a safe time window for an agricultural processing in the overlap zone in dependence on the animal protection time window, the safe time window having no temporal overlap with the animal protection time window.

In the framework of the present description, the term "simulating" is to be understood broadly, including predicting, calculating, estimating or modelling or the like. Thus, simulating a life-cycle of the animal species may be accomplished by predicting, estimating, calculating or modelling or of the like the life-cycle of the animal species.

Since the safe time window for an agricultural processing in the overlap zone is determined in dependence on the animal protection time window and since the safe time window does not temporally overlap with the animal protection time window, a negative effect to animals in the overlap zone may be avoided by performing agricultural processing (which may negatively affect the animal species) in the overlap zone only during the safe time window. This may allow reducing costs or effort, for example, since no marking, tracking, and removing of individual animals from the agricultural zone, e.g., the crop field, is required.

The agricultural system according to the invention has the further advantage that a higher level of automation can be achieved. In particular, with the agricultural system it is not necessary to actively visit the agricultural zone in person to figure out when agricultural processing may be performed without unacceptably affecting an animal species that is potentially present in the agricultural zone. Moreover, it is not necessary to regularly verify the life stage of such an animal species to assess whether according to the current life stage of the animal species agricultural processing may be performed without unacceptably affecting the animal species.

The agricultural system according to the invention has the further advantage that protection of the animal species and agricultural processing can be better aligned to each other. Alignment of animal protection and agricultural processing may even be reliably accomplished in terms of specific days during a year. It is thus possible to plan the agricultural processing to be performed on a specific crop field constituting an agricultural zone way in advance. This also allows making a plan of which of a plurality of agricultural zones should be processed in which order to suit best to the requirement of protecting an animal species present in at least one of the agricultural zones.

The agricultural system according to the invention has the further advantage that the precision of agricultural treatments can be increased. In particular, with the agricultural system it is possible to reliably determine a time range, e.g., a preferred time window, during which agricultural processing is particularly favourable for crop growth, yield and quality and at the same time the risk of negatively affecting an animal species is reduced. This may be accomplished by the agricultural system since for determining the right time for agricultural processing at least one of the current life stage of the animal species in the animal protection zone and the current growth stage of crop of the agricultural zone may be taken into account.

Agricultural zone data and/or protection zone data may be technical data, in particular, weather data, geographical data, agronomic data, sensor, camera or satellite data, GPS data, location data and the like.

Agricultural zone data may represent a location and a spatial extent of an agricultural zone in which agricultural processing is planned, e.g., in terms of geographic coordinates.

Protection zone data may represent the type of animal to be protected, i.e., the animal species, and a location and a spatial extent of the animal protection zone associated with the animal species.

Agricultural zone data and/or protection zone data may be generated, e.g. automatically generated, by the agricultural system, e.g., upon selecting a certain area on a digital map. A selection of a certain area on a digital map may be performed based on user input, publicly or commercially available geographical information. Agricultural zone data and/or protection zone data may be generated upon providing certain information to the agricultural system. For example, a user may input the name of a location or geographic coordinates of a location or geographical information into the agricultural system and based on this information the agricultural system then generates respective agricultural zone data and/or protection zone data. As elaborated in more detail below, geographical information may include a location of the respective zone and area information of the respective zone.

Additionally, or alternatively, agricultural zone data and/or protection zone data may be obtained by the agricultural system, e.g., from a database stored on an external server. Obtaining may include actively requesting data with the agricultural system from the database, i.e., data transmission is initiated by the agricultural system. Obtaining data may also include retrieving data from a database to the agricultural system, i.e., data transmission is initiated by an external server storing the database.

The animal species may be, e.g., a bird species or an amphibian species, preferably a toad species such as common toad, a frog species, a newt species or a salamander species. The animal species may be, for example, an amphibian species of which amphibians start as larvae in a water body and grow into adults via a metamorphic form. All of these amphibian species have similar life-cycles of which some are time-shifted with respect to each other. The life-cycles generally comprise a first stage in which animals of the animal species are present in form of an egg and then living as a tadpole in a water body. Subsequently, metamorphs move to and live on land close to their natal pond, e.g., in case of common toads within a zone of approximately 290 metres around their natal pond.

The invention includes the recognition that some animal species might be negatively affected by certain agricultural processing during certain life stages in their life-cycle. For example, common toads may be negatively affected under specific circumstances during certain life stages in their life-cycle by applying chemical products, such as plant protection products when they are young and small, i.e., when they are metamorphs. This is likely primarily caused by their relatively high surface-to-mass ratios. Depending on their life-cycle, the toad metamorphs are present in or close to their natal pond. Typically, common toad metamorphs stay within a zone of approximately 290 metres around their natal pond until they are robust enough to start migrating to their winter habitat. An animal protection zone for a pond accommodating common toad metamorphs may be defined as a zone surrounding a pond or water body, extending up to about 290 metres from the water body. For other animal species, other animal protection zones may be defined. For example, for other animal species, an animal protection zone may be defined with respect to a forest and may include a zone surrounding that forest. A surrounding zone, surrounding a forest or a pond may only extend for several metres from the forest or pond, e.g., 10 metres, and may in other cases extend far beyond 290 metres such as up to 500 metres depending on the specific animal species potentially living in the respective animal protection zone.

In certain cases, the agricultural zone, such as a crop field, may at least partly spatially overlap with the animal protection zone. In the agricultural zone, various forms of agricultural processing need to be performed in order to grow the crops. In order to protect the animal species, no agricultural processing which may negatively affect the animal species and more particular certain life stages, should be performed within the overlap zone during the animal protection time window. The overlap zone may be defined by the spatial overlap of the agricultural zone, e.g., crop field, and the animal protection zone.

However, if the animal species, e.g., the toad metamorphs, have either left or are not yet present in the overlap zone, agricultural processing that would negatively affect the metamorphs may be performed in such an overlap zone. Furthermore, agricultural processing may be performed in an overlap zone although the to-be-protected animal species is potentially present therein if, for example, a soil load is expected to be below a predefined ecotoxicological threshold. This may be the case when crop interception is sufficiently high. Crop interception is characterized by the relative quantity of, e.g., a chemical product that does not reach the soil surface. This means, if the interception is high, the soil load is small.

For example, the crop in the overlap zone may have reached a growth stage in which it covers a large amount of the soil such that a sufficiently reduced amount of a chemical product will actually reach the soil and potentially present animals. A large cop cover may thus yield a large crop interception and a small soil load.

The agricultural system may be used for determining the safe time window based on the life stage of the animal species. The safe time window may correspond, e.g., to a time range such as a number of favourable days for performing agricultural processing in the overlap zone. Thereby, the agricultural system enables a user to obtain knowledge when it is possible to perform agricultural processing in the overlap zone without taking an unacceptable risk to negatively affect the animal species. For example, the agricultural system may be configured to provide a forecast, e.g., a ten-day forecast, when performing agricultural processing is possible with an acceptable risk of negatively affecting the animal species or more particular certain life stages of the animal species.

This is accomplished by the agricultural system by determining the life stage of the animal species, the animal protection time window based on the life stage, the overlap zone and the safe time window for an agricultural processing in the overlap zone. In particular, from the life stage of the animal species it may be derived by the agricultural system whether or not, for example, metamorphs of the animal species are currently present in the overlap zone. Based on the life stage of the animal species, the agricultural system may thus determine an animal protection time window that represents a time range during which no agricultural processing which may negatively affect the animal species is to be performed in the overlap zone. During the animal protection time window, for example, metamorphs of the animal species are expected to be present in the overlap zone. Based on the animal protection time window, the agricultural system determines the safe time window for an agricultural processing in the overlap zone. The overlap zone is determined from the spatial overlap between the agricultural zone and the animal protection zone. During the safe time window, agricultural processing in the overlap zone may be performed without negatively affecting animals of the animal species and more particularly, certain life stages of the animal species.

Agricultural processing relates to all work performed in order to grow crops in an agricultural zone, e.g., a crop field, and in order to harvest crops. Agricultural processing which may negatively affect the animal species, more particularly, at certain life stages of the animal species, may include, for example, seeding, applying a chemical product, harvesting, or any other agricultural processing which may negatively affect the animal species. Whether a specific agricultural processing may negatively affect the animal species depends on the animal species, its life stage as well as the specific agricultural processing. For example, while applying a certain chemical product in the overlap zone may negatively affect certain animal species, other animal species may not be affected by that chemical product. Furthermore, whether or not applying of the certain chemical product in the overlap zone would negatively affect a certain animal species may depend on the concentration and/or amount of an applied chemical product. In other words, for determining the safe time window, preferably, only agricultural processing which may negatively affect the animal species is considered, since performing agricultural processing which may not negatively affect the animal species may be performed even during the animal protection time window.

The animal protection zone may correspond to a zone in which the animal species, which may be negatively affected by agricultural processing, is at least temporally present. Animal species may live temporally in different animal protection zones and different groups of the animal species may live in different animal protection zones, which may have an overlap zone with the agricultural zone. Two different life stages of the animal species may be, for example, adults and metamorphs. The animal protection zone may, for example, include one or more of forests and water bodies, as well as zones surrounding water bodies and/or forests. An extension of the zones surrounding a water body may be fixed for a certain animal species, e.g., 290 m around a water body for common toad metamorphs, or may depend on further parameters, e.g., environmental parameters such as weather conditions, e.g., temperature, humidity, or precipitation, or any other environmental parameter, which is, e.g., indicative of a life stage of the animal species.

The animal protection zone, preferably, is a zone in which the animal species lives or in which the animal species is present for a certain period during the animal species' life-cycle. An animal protection zone may also comprise a migration route of the animal species. Preferably, the animal protection zone is defined by boundaries enclosing a zone comprising at least one water body and land surrounding the water body or water bodies. The animal protection zone may be defined, for example, as a zone in which the animal species, particularly a certain life stage, e.g. metamorphs, is present during a certain life stage of the animal species with a certain likelihood, e.g., 80 % or 90 %. The boundary of an animal protection zone may be determined, for example, based on a constant distance from a bank of the water body. For example, the animal protection zone may extend up to 290 or up to 300 metres radially from the bank of the water body. The surrounding zone associated with one water body may overlap with the surrounding zone of other water bodies thus forming an animal protection zone that is merged from two or more surrounding zones.

The overlap zone is a zone in which agricultural processing is planned to be performed as it is part of the agricultural zone. At the same time, the overlap zone is a zone in which the animal species may potentially be present. If the animal species is present in the overlap zone, in general, no agricultural processing which may negatively affect the animal species should be performed in the overlap zone in order to protect the animal species. This may still include that agricultural processing is performed although a to-be-protected animal species is potentially present in the overlap zone. For example, agricultural processing may be performed with adapted agricultural processing parameters so that an animal species potentially present in the overlap zone is not unacceptably affected. Furthermore, agricultural processing may still be performed without negatively affecting an animal species if, for example, the crop interception is sufficiently high. For example, a crop in the overlap zone may have reached a growth stage such that it covers a large amount of the soil such that the soil load of a chemical product is sufficiently reduced. In order to determine when the animal species most probably is present in the overlap zone, the agricultural system is configured to employ the animal life-cycle model of that animal species allowing to determine a current life stage within the life-cycle of that animal species.

The animal protection time window corresponds to a certain time range during which the animal species, particularly certain life stages, e.g. its metamorphs, may be negatively affected by the agricultural processing. The animal life-cycle model depends on the animal species, e.g., an amphibian species such as the common toad. The animal life-cycle model may be a statistical model, e.g., a regression model. The animal life-cycle model may include, for example, for amphibians three life stages for young animals, respectively, namely a first life stage in which they are eggs or tadpoles in a water body, a second life stage in which they are metamorphs on land close to their natal ponds, e.g., within a 290 m distance of their natal pond, and a third life stage in which they are grown metamorphs or juveniles moving through an extended part of the agricultural zone. The animal protection time window may include, for example, the second life stage and/or the third life stage. An additional ten days may be, for example, added after metamorphs start to disperse.

For example, the agricultural system may comprise:
- an agricultural zone data providing unit that is configured for obtaining or generating agricultural zone data indicative of an agricultural zone in which agricultural processing is planned,
- an animal protection zone data providing unit that is configured for obtaining or generating protection zone data indicative of the animal protection zone that is associated with the animal species present therein,
- an animal life-cycle model providing unit that is configured for providing an animal life-cycle model which is configured for simulating a life-cycle of the animal species,
- a life stage determination unit that is configured for determining one or more life stages of the animal species based on the animal life-cycle model,
- an animal protection time window determination unit that is configured for determining an animal protection time window based on the life stage of the animal species during which no agricultural processing which may affect, in particular, negatively affect, the animal species is to be performed in the animal protection zone in order to protect the animal species,
- an overlap zone determination unit that is configured for determining an overlap zone as a spatial overlap between the agricultural zone and the animal protection zone based on the agricultural zone data and protection zone data, and
- a safe time window determination unit that is configured for determining a safe time window for an agricultural processing in the overlap zone in dependence on the animal protection time window, the safe time window having no temporal overlap with the animal protection time window.

The agricultural system may further include an output unit that is configured for providing or generating a safe time window signal based on the determined safe time window. Preferably, a provided safe time window signal is suitable for controlling an agricultural device to perform agricultural processing within a determined overlap zone during the determined safe time window. In particular, it is preferred that the provided safe time window signal is suitable for controlling an agricultural device to not perform agricultural processing or to perform it differently by changing its agricultural processing parameters within an overlap zone during the determined animal protection time window.

For example, the agricultural zone data providing unit, the protection zone data providing unit and/or the output unit may be part of a communication interface that is configured for receiving and/or transmitted agricultural zone data, protection zone data, and/or a safe time window signal, respectively. A safe time window signal may represent safe time window data indicative of a determined safe time window. The agricultural zone data providing unit and/or the protection zone data providing unit may also be implemented as a memory component or cloud that stores and provides respective agricultural zone data and/or protection zone data. The animal life-cycle model providing unit may be a memory component or cloud that stores and provides the animal life-cycle model. The agricultural system may further comprise an agricultural growth model providing unit that is configured for providing an agricultural growth model. The agricultural growth model providing unit may be a memory component or cloud that stores and provides the agricultural growth model. The agricultural system may further comprise a growth stage determination unit configured for determining a growth stage of a crop growing or to be grown in the agricultural zone based on the agricultural growth model. Preferably, the agricultural system, e.g., a growth stage determination unit, is configured for determining a crop interception indicative of relative amount of a chemical product reaching a soil surface within the overlap zone, wherein the system is configured for determining the animal protection time window in dependence on the determined crop interception. Moreover, the agricultural system, e.g., a growth stage determination unit, may be further configured for determining a growth stage of a crop growing or to be grown in the agricultural zone, the growth stage being determined based on the agricultural growth model and for determining the animal protection time window in dependence on the determined growth stage. Additionally or alternatively, the agricultural system, e.g., a growth stage determination unit, may be configured for determining a crop interception based on the growth stage of the crop using an agricultural growth model and for determining a soil load using the determined crop interception, wherein for determining the animal protection time window, the agricultural system, e.g., a growth stage determination unit, is configured to evaluate the determined soil load in relation to a predefined ecotoxicological threshold.

The life stage determination unit, the growth stage determination unit, the animal protection time window determination unit, the overlap zone determination unit and the safe time window determination unit may be implemented as one or more processors or processing units. The one or more processors can be part of the same computing device or can be distributed over several different processing devices.

Accordingly, the agricultural system may include a communication interface, a processor, and a memory component. The communication interface may include a transceiver and one or more antennas for exchanging data such as agricultural zone data, protection zone data, a safe time window signal and/or weather data. Alternatively, or additionally, the communication interface may include a user interface for interacting with a user, such as a keyboard, a display, a mouse, a touch display, or the like. The processor may be configured for processing data, such as agricultural zone data, protection zone data and/or weather data, e.g., by performing calculations. The processor may be configured for determining the overlap zone and for determining the safe time window. The memory component may be configured for storing data, e.g., in a database.

The animal life-cycle model may be configured for simulating the life-cycle of the animal species based on environmental parameters, particularly based on weather data. The weather data may be used as input to the animal life-cycle model for determining the life stage within the life-cycle of the animal species. The agricultural system may be configured, for example, for estimating the life stage of the animal species based on the weather data using the animal life-cycle model. The animal life-cycle model may be generated based on or may use as input weather data including, for example, soil temperature at a certain depth, air temperature, and precipitation, as well as tracking data of locations of the animal species in dependence on weather data, in particular of grown animals, and catching locations of young animals, e.g., based on fences put at different distances to a birth location of the animals.

The weather data may be stored, e.g., in the database of the agricultural system. The weather data may also be stored in any other database, which may be accessed by the agricultural system, e.g., on one or more external servers connected to the agricultural system. For example, external servers may include a weather satellite network or weather station network. The external servers may receive data from sensors sensing weather information including, for example, precipitation, temperature, and humidity. The weather information may, for example, include soil temperature, air temperature, humidity, and precipitation. The external servers may gather the weather information and form weather data from the weather information.

The weather data may comprise historical climate data, e.g., including weather information of the last one or more years, such as the last two, the last three, the last four, or the last five years. The weather information may also be used for providing a weather forecast, i.e., the weather to be expected in the future, e.g., a ten-day weather forecast, which may be included in the weather data. The agricultural system may be configured for simulating the life-cycle of the animal species for the future, e.g., based on the weather forecast included in the weather data.

The weather data may include a measured air temperature and/or a soil temperature, e.g., a temperature profile of the last two years or an expected temperature profile, e.g., for the upcoming ten days as a weather forecast. The weather data may alternatively, or additionally, include a measured amount of precipitation, e.g., a precipitation profile representing the amount of precipitation during the last two years. The weather data may also include a weather forecast, e.g., a ten-day weather forecast for an expected amount of precipitation.

The agricultural system, e.g., an animal protection time window determination unit, may be configured for using the animal life-cycle model for determining based on the weather data when migration of an animal species starts, when the animal species reproduces, and/or when the animal species' offspring is to come up. One or more of these events may be influenced by certain air, water, and/or soil temperatures, as well as precipitation.

The agricultural system may be further configured for obtaining the weather data based on geographical information of the agricultural zone, or based on a geographical information of the animal protection zone, or based on the geographical information of the agricultural zone and the geographical information of the animal protection zone, e.g. via a communication interface.

The geographical information of a respective zone may, for example, include a location of the respective zone and area information of the respective zone. The location of the respective zone may correspond, for example, to a specific point of the respective zone, such as a centre of the respective zone or any other point of the respective zone. The area information may include an area indicating a quantity that indicates an extent of the respective zone in two-dimensions. The area information may additionally include border information of the respective zone including, for example, border coordinates of the respective zone indicating the limits or boundaries, respectively, of the respective zone.

The agricultural system may be configured for obtaining the weather data based on the location of the animal protection zone, the agricultural zone, or the location of the animal protection zone and the agricultural zone. For example, the weather data may be acquired, for example, by a weather station near or within the animal protection zone. This may allow to provide more accurate weather data and thus may allow to more accurately predict the life stage of the animal species.

The geographical information may be, for example, provided by a user via the communication interface. For example, the user may provide a location. The area information of the zones may then be selected from a database based on the location. Additionally, or alternatively, at least part of the geographical information about the agricultural zone and/or the animal protection zone may, for example, be provided by or received from the database. The database may be included in the agricultural system, e.g., in the memory component. Alternatively, the database may also be separate to the agricultural system, e.g., stored on one or more external servers, such as weather stations or weather satellites. Geographical information of the animal protection zone may, for example, be received from the same database or another database. The geographical information of the agricultural zone and the geographical information of the animal protection zone may be stored in the same database or in different databases. The database may include a list of respective zones and their respective area information associated to a respective location of a respective zone as the geographical information.

Additionally, or alternatively, the database may include the geographical information in form of image data including, for example, satellite images or other images taken from above, e.g., from an airplane, balloon, or drone, associated to respective locations. The image data may, for example, include a digital map, such as a topographic or geographical map. The agricultural system may be configured for determining the location of the respective zone and the area information of the respective zone based on the image data of the respective location, e.g., by performing image recognition. For example, a respective zone may be determined based on one or more features of the respective zone. Features of the agricultural zone may include different colouring compared to neighbouring zones and specific shape features. Features of the animal protection zone may include features indicative of water bodies, forests, or mountains, such as irregular border shapes, blue colouring, or irregular shapes of objects within the zone, such as trees or rocks.

The respective locations may be, for example, location names or geographical positions, e.g., provided in spherical coordinates, map coordinates projected onto a plane, earth-centred, earth-fixed (ECEF) Cartesian coordinates, or a geocode. The respective locations may be provided, for example, by a user, as global positioning system (GPS) coordinates or location names.

The agricultural system, e.g., an agricultural zone data providing unit, may also be configured for selecting the agricultural zone based on the geographical information and for receiving image data of an environment around the agricultural zone. The agricultural system, e.g., an animal protection zone data providing unit, may be configured for determining the animal protection zone from the image data, e.g., based on image recognition. This allows to select a specific agricultural zone and to automatically detect animal protection zones close to the agricultural zone, in particular animal protection zones spatially overlapping with the agricultural zone. For example, the agricultural system may be configured for automatically determining the animal protection zone by identifying a water body. The agricultural system may be configured for further determining a zone surrounding the water body based on a predefined criterion, e.g., the zone having a boundary at a constant distance calculated from a bank of the water body. This zone may also have a larger extension in one direction compared to another direction with respect to, e.g., the water body. For example, if there is no agricultural zone but a forest on one side of the water body, the surrounding zone may not extend into the forest, while this is the case on another side of the water body where there is an agricultural zone.

Alternatively, or additionally, the animal protection zone may also be defined by a user, e.g., using the communication interface, for example, including a display on which a digital map is visualized. The user may provide boundaries of the animal protection zone as input to the agricultural system.

Alternatively, or additionally, the animal protection zone may be automatically determined, e.g., by an animal protection zone data providing unit, based on habitats of the animal species indicated on a digital map. The habitats may be assigned to different life stages of the animal species, e.g., based on the animal life-cycle model. This digital map may be superimposed with a topographic map showing, e.g., the agricultural zone for visualizing the overlap zone.

The agricultural zone may also be defined by user input using the communication interface and, e.g., obtained by an animal protection zone data providing unit. For example, a display may display a digital map showing a location based on input by the user. The user may select boundaries of the agricultural zone on the map and the agricultural system may be configured for determining based on the user input the agricultural zone and its location and area information. Alternatively, the geographical positions of the boundaries of the agricultural zone may be provided as longitude and latitude.

The agricultural system, e.g., an overlap zone determination unit, may be configured for determining the overlap zone and its geographical information based on the geographical information of the animal protection zone and the geographical information of the agricultural zone.

The agricultural system, e.g., an animal protection time window determination unit, may be configured for determining a likelihood of a presence of the animal species in the agricultural zone, in particular, in the overlap zone, based on the simulated life-cycle of the animal species. For example, while the animal species lives as tadpoles in the natal water body or natal pond, the animal species will not be present in the overlap zone. However, as the tadpoles grow to metamorphs, the metamorphs will leave the natal water body and move potentially into adjacent crop fields. Thus, in dependence on the life stage as determined from the simulated life-cycle of the animal species, a likelihood of a presence of the animal species in the agricultural zone, particularly in the overlap zone, may be determined, e.g., by an animal protection time window determination unit.

The animal life-cycle model may be a statistical model configured for determining spatio temporal scores indicating the likelihood of the presence of the animal species in the agricultural zone, in particular, in the overlap zone, based on the life stage of the animal species. The likelihood of the presence of the animal species in the agricultural zone, in particular, in the overlap zone, may additionally or alternatively, depend on the weather data.

The agricultural system, e.g., a safe time window determination unit, may be configured for determining the safe time window based on the determined likelihood of the presence of the animal species in the agricultural zone, in particular, in the overlap zone. For example, a threshold value for the likelihood of the presence of the animal species in the agricultural zone, in particular, in the overlap zone, may be defined below which the animal species is expected not to be present or to be present within the agricultural zone with a negligible probability. Since the animal species will migrate to their winter habitat at some point of time, the likelihood of the presence of the animal species in the agricultural zone will be below the threshold value after the animal species migrated to their winter habitat. Furthermore, before the metamorphs are present in the agricultural zone, in particular, in the overlap zone, the likelihood of the presence of the animal species in the agricultural zone, in particular, in the overlap zone, is also below the threshold value. The animal protection time window may be determined, for example, as the time range between the occurrence of the metamorphs in the agricultural zone, in particular, in the overlap zone, and their migration to the winter habitat. The safe time window may then, for example, correspond to the time range, which does not overlap with the animal protection time window, i.e., all the time before occurrence of the metamorphs and all the time after their migration to the winter habitat.

The agricultural system, e.g., an output unit, may be configured for providing a safe time window signal based on the determined safe time window. The safe time window signal may include or may be a control signal usable for controlling an agricultural device, e.g., a robot, such as a flying drone or a tractor or an application robot or an agricultural application robot, preferably, to perform agricultural processing in the overlap zone during the safe time window. This may allow controlling the agricultural device, e.g., a robot, in order to reduce the risk of negatively affecting the animal species during agricultural processing.

An agricultural device may comprise any machine that is capable of performing agricultural processing comprising seeding, fertilizing, applying plant protection products, harvesting, or performing any other agricultural processing in an agricultural zone, e.g., a crop field.

An agricultural device may comprise or be a tractor, or a robot, or a flying drone or an application robot or an agricultural application robot.

An agricultural device may be configured for performing the agricultural processing fully autonomously. An agricultural device that is configured for performing the agricultural processing fully autonomously is preferably configured for sensing its environment and moving and performing agricultural processing with little or no human input.

An agricultural device may be configured for performing the agricultural processing primarily upon human input, i.e., the agricultural device is primarily controlled by a human being. In this case, the driver or user of the agricultural device may be instructed by the agricultural system of when to perform agricultural processing in a certain agricultural zone without negatively affecting an animal species.

An agricultural device may comprise a data input unit that may be configured for receiving a safe time window signal usable for controlling the agricultural device. The agricultural device may further comprise a control unit that is configured for processing a received safe time window signal and for controlling the agricultural device according to the information contained in the safe time window signal. Thereby it is possible to remotely control the agricultural device by transmitting a safe time window signal that is received by the data input of the agricultural device. An agricultural device may further comprise a data output for providing an agricultural device signal that, e.g., may be generated by the agricultural device's control unit. An agricultural device signal may represent status information of the agricultural device such as an error message or the like. An agricultural device signal may be generated such that it may be usable to be received by an agricultural system and, in particular, by an electronic device of an agricultural system. For example, an agricultural device signal may be provided to be received by an antenna array or a transceiver of a communication interface of the agricultural system's electronic device. A provided agricultural device signal may be processed by a processor of the agricultural system and information contained in the agricultural device signal may be displayed to a user by means of a display, e.g., of the electronic device.

The safe time window signal may be transmitted by the agricultural system, e.g., by its electronic device, for example, by its output unit, to be processed by an agricultural device. The safe time window signal may include or may be an information signal usable for providing an information about the safe time window, for example, to the agricultural device or to a user. The safe time window signal may be a display signal, for displaying the safe time window on a display or an audio signal for acoustically providing information about the safe time window by a speaker. The agricultural device may be configured for presenting the information about the safe time window to the user, e.g., visually and/or acoustically. The agricultural device may, for example, comprise an agricultural device communication interface, e.g., a display for visualizing an information about the safe time window and/or a speaker for acoustically providing the information about the safe time window to the user.

Additionally, or alternatively, the agricultural system may be configured, for example, for displaying the safe time window during which agricultural processing which may negatively affect the animal species may be performed in the overlap zone with an acceptable risk of negatively affecting the animal species on the display of the communication interface. The agricultural system may also be configured for displaying the agricultural zone, the animal protection zone, and the overlap zone on the display.

The agricultural system may comprise an agricultural device such as a robot configured for performing the agricultural processing in the agricultural zone based on the safe time window signal. Alternatively, the agricultural system may be configured for controlling an agricultural device such as a robot external to the agricultural system based on the safe time window signal.

The safe time window signal may be a control signal usable for controlling the agricultural device such as a robot or may be usable to be processed by the agricultural device to adapt the operation of the agricultural device according to the information contained in the safe time window signal. The agricultural device such as a robot may be an autonomous flying drone or autonomous tractor. The agricultural device such as a robot may be configured for performing agricultural processing which may negatively affect the animal species in the overlap zone during the safe time window.

The agricultural system, e.g., an agricultural processing time window determination unit, may be configured for determining an agricultural processing time window. The agricultural processing time window may indicate a time range in which agricultural processing in the agricultural zone is required or in which agricultural processing in the agricultural zone is at least beneficial for the yield, for example, as during the agricultural processing time window pest pressure is high. The agricultural processing time window may be a time range within or at least partly overlapping with the safe time window. Alternatively, the safe time window may be a time range within the agricultural processing time window, which does not overlap with the animal protection time window. The agricultural processing time window may be a time range within or at least partly overlapping with the animal protection time window. Preferably, agricultural processing is only performed in a preferred time window that is a time window defined by an overlap of the agricultural processing time window and the safe time window. During the preferred time window, agricultural processing is beneficial for the crop and at the same time not unacceptably affecting the animal species. The preferred time window is thus fully comprised within the safe time window. Preferably, agricultural processing is not performed during an overlap time window that is defined by an overlap of the animal protection time window and the agricultural processing time window. The information about the preferred time window may be contained in a safe time window signal usable for controlling an agricultural device.

The agricultural device such as a robot may be configured for performing agricultural processing which may not negatively affect the animal species in the agricultural zone during the agricultural processing time window. The agricultural device such as a robot may also be configured for performing agricultural processing which may negatively affect the animal species in the agricultural zone except for the overlap zone during the animal protection time window. The agricultural system may be configured for causing the agricultural device such as a robot to adapt the agricultural processing in the overlap zone during the animal protection time window such that the agricultural processing in the overlap zone does not unacceptably affect the animal species or is at least less affecting the animal species in order to reduce the risk of negatively affecting the animal species. This allows reducing the risk of negatively affecting the animal species during agricultural processing.

Preferably, the agricultural system is configured for performing or controlling the agricultural processing in the overlap zone during the safe time window. Preferably, the agricultural system is configured for controlling an agricultural device such as a robot to perform agricultural processing in the overlap zone during the safe time window.

The agricultural system may be configured, for example, for performing agricultural processing, such as applying a chemical product, in the agricultural zone including the overlap zone during the safe time window. The agricultural system may, for example, cause an agricultural device such as a robot to perform the agricultural processing in the agricultural zone and in particular the overlap zone during the safe time window.

The agricultural system may be configured for adapting the agricultural processing in the agricultural zone, e.g., by controlling an agricultural device, such that no agricultural processing is performed in the overlap zone during the animal protection time window. This allows ensuring that negatively affecting animals by agricultural processing is reduced since no agricultural processing which may negatively affect the animal species is performed during the animal protection time window in the overlap zone. Meanwhile, other agricultural processing in the overlap zone, which does not unacceptably affect the animal species may be performed during the animal protection time window. In addition, agricultural processing which may negatively affect the animal species may be performed in the agricultural zone excluding the overlap zone during the animal protection time window. This may allow an optimized zone-based or sub zone-based agricultural processing.

The agricultural system, e.g., an output unit, may be configured for providing an adaption signal, e.g., a control signal usable for controlling an agricultural device such as a robot or an information signal usable for providing an information to the user for adapting the agricultural processing to an agricultural processing which is not unacceptably affecting the animal species in the overlap zone during the animal protection time window. For example, if the agricultural processing is performed in form of applying a chemical product, the concentration of the chemical product may be adapted in the overlap zone or another chemical product may be applied in the overlap zone in order to not to unacceptably affect the animal species. This allows reducing a risk of negatively affecting the animal species. Furthermore, some agricultural processing may be performed even during the animal protection time window in the overlap zone. This may improve efficiency of the agricultural processing and may furthermore increase the yield and/or the quality.

The agricultural system may be configured for obtaining a growth stage of a crop growing or to be grown in the agricultural zone, e.g., with a growth stage determination unit. Obtaining the growth stage of the crop may include obtaining or receiving the growth stage of the crop based on user input or determining the growth stage of the crop based on an agricultural growth model configured for simulating the growth of the crop. The agricultural system may be configured for performing or controlling the agricultural processing in the overlap zone during the safe time window in dependence on the growth stage of the crop. Alternatively, or additionally, the agricultural system may be configured for determining the agricultural processing time window based on the growth stage of the crop. The agricultural system may be configured for determining the agricultural processing time window, e.g., with an agricultural processing time window determination unit, such that it is included within the safe time window. In other words, the agricultural processing time window may be limited to a time range that does not temporally overlap with the animal protection time window. Alternatively, the agricultural system may be configured for determining the safe time window, e.g., with a safe time window determination unit, additionally based on the agricultural processing time window such that the safe time window is included in the agricultural processing time window and does not overlap with the animal protection time window. In particular, the agricultural system may be configured for determining a preferred time window for agricultural processing that is defined by an overlap of the safe time window and the agricultural processing time window. This allows providing a safe time window, which allows providing an improved yield and/or quality of the crop while protection of the animal species may be ensured.

A crop or crops in the sense of this text are to be understood as any plants providing yield that may be harvested in the agricultural zone. Crops may include, for example, wheat, corn, soybeans, grass, or any other plants providing yields in whatever form. Typically, the crop is seeded on a field at a first point in time in order to grow and to be harvested at a later point in time. Crops may also include perennial plants, such as fruit trees, which are seeded or planted at a first point in time and grow over time such that they may provide fruits over a longer period of time, such as over several years. The yield that can be harvested in the agricultural zone from the plants depends on the agricultural processing in the agricultural zone.

The agricultural processing time window may correspond to a time range in which agricultural processing should be performed in order to optimize the yield provided by the plants and/or its quality. For example, the agricultural processing time window may indicate a growth phase of the plants, during which the plants are vulnerable to pests. During this phase, pests need to be prevented from damaging the plants. For example, the plants may be protected with a chemical product applied during the agricultural processing time window in order to prevent the pests from damaging the plants.

The agricultural growth model may be, for example, configured to use as input a crop type and/or a planting date. The crop type and/or the planting date may be obtained from or received, e.g., by a user. The agricultural growth model may be crop type specific, i.e., considering peculiarities of the crop type during growth. For example, different crop types may be affected by different pests and may need different agricultural processing in order to optimize their yield in the agricultural zone. In particular, different agricultural processing, such as applying chemical products, may have to be performed during different agricultural processing time windows for different crop types. The agricultural growth model may be configured for determining a growth stage of the crops in the agricultural zone based on the crop type and the planting date. Optionally, the agricultural growth model may be configured for using further input parameters for determining the growth stage of the crop. Further input parameters may include, for example, which chemical products are to be applied or environmental parameters, such as soil type of the agricultural zone, an actual pest pressure, weather information, e.g., temperature or precipitation, or any other environmental parameter indicative of a status of the plants. The agricultural growth model may, for example, be configured for simulating the growth stage of the crop based on weather data.

Alternatively, the growth stage of a crop may be obtained from or received, e.g., by the user based on user input. The agricultural growth model may be configured for determining the agricultural processing time window based on the growth stage of a crop, e.g., during which time window the agricultural processing should be performed in order to optimize the yield. The growth stage of a crop may be, for example, the Biologische Bundesanstalt, Bundessortenamt and Chemical industry (BBCH) growth stage and the growth stage of a crop may be indicated by a BBCH value as defined, for example, in "Growth stages of mono- and dicotyledonous plants BBCH Monograph" edited by Uwe Meier and published in Quedlinburg in 2018 (DOI: 10.5073/20180906-074619). For example, for winter wheat, the agricultural processing time window for applying a fungicide may be between BBCH 30 and 65 due to high pest pressure during this time window.

Preferably, the agricultural system is configured for determining a growth stage of a crop growing or to be grown in the agricultural zone based on an agricultural growth model, wherein the agricultural system is configured for performing the agricultural processing in the overlap zone during the safe time window in dependence on the growth stage of the crop. Alternatively, the agricultural system may be configured for determining an agricultural processing time window based on the growth stage of the crop, the agricultural processing time window indicating a time range in which agricultural processing is to be performed in the agricultural zone.

The growth stage of a crop may also be used to more accurately determine the animal protection time window. That is, if the crop has reached a certain growth stage, the crop may contribute to protecting an animal species living on the soil. For example, at a certain growth stage, a crop may cover the ground to an extent that only a reduced amount of a chemical product that is applied on a crop field actually reaches the soil and thus potentially the animal species. In other words, the crop interception, i.e. the relative amount of a chemical product that actually is not reaching the soil, can be significantly increased if the crop covers the soil to a large extent. It is therefore possible to take into account the growth stage of a crop and, in particular, based thereon, the crop interception, to more accurately determine to which extent a chemical product will actually reach the soil. If the crop interception is large enough, it may be possible to apply a chemical product in an overlap zone although a to-be-protected animal species may potentially be present therein. This means, when taking into account the growth stage of a crop and in particular the crop interception, it may be possible to determine an animal protection time window that has a reduced time duration in comparison to an animal protection time window that has been determined without considering the growth stage of a crop.

Accordingly, it is preferred that the agricultural system is further configured for determining a crop interception for determining the animal protection time window in dependence on the determined growth stage of the crop.

For example, the agricultural system may be configured for determining a growth stage of a crop growing or to be grown in the agricultural zone based on an agricultural growth model and for determining the animal protection time window in dependence on the determined growth stage of the crop. Preferably, the agricultural system is configured for determining a crop interception based on the determined growth stage. Furthermore, the agricultural system may be configured for using the determined crop interception to determine a soil load. Preferably, for determining the animal protection time window, the agricultural system, e.g., an animal protection time window determination unit, is configured to evaluate the determined interception and/or soil load in relation to a predefined ecotoxicological threshold. For example, if the determined soil load is above the predefined ecotoxicological threshold, a safe time window signal may be generated suitable for controlling an agricultural device to not to perform agricultural processing in the overlap zone. Yet, if the determined soil load is below the predefined ecotoxicological threshold, a safe time window signal may be generated suitable for controlling an agricultural device to perform the agricultural processing in the overlap zone.

In operation of the agricultural system that is configured for determining a crop interception, e.g., by determining a growth stage of a crop growing or to be grown in the agricultural zone, the agricultural system may determine an exposure of a chemical product to the animal species in the overlap zone in the animal protection time window based on simulated crop interception using, e.g., a simulated BBCH stage as basis. Based on the determined crop interception, the exposure reaching the soil (called the soil load), i.e. the area where the animal species might be present (e.g., in case of amphibians), may be calculated and compared to an ecotoxicological threshold, which is typically set by regulatory authorities approving plant protection products. In case the soil load is below the ecotoxicological threshold, the animal protection time window will change to a safe time window and will allow the agricultural processing in the overlap zone. In case the soil load is higher than the ecotoxicological threshold, the agricultural processing will not be performed or the agricultural system might determine, which change of the agricultural processing parameters, e.g. a reduction of the concentration or of the applied amount of a chemical substance would be needed to turn the animal protection time window to a safe time window, which can be used to generate a signal. It is thus possible to determine with the agricultural system a set of one or more agricultural processing parameters that result in an agricultural processing yielding a soil load that is below an ecotoxicological threshold. If such a set of one or more agricultural processing parameters can be determined, agricultural processing may nevertheless be carried out in the overlap zone although a to-be-protected animal species is potentially present therein.

The agricultural system may be configured for adapting the agricultural processing in the agricultural zone such that agricultural processing performed in the overlap zone during the animal protection time window is not unacceptably affecting the animal species or does not unacceptably affect the animal species.

The agricultural system may be configured for providing an agricultural processing time window signal. The agricultural processing time window signal may include information about the agricultural processing time window and/or represent the agricultural processing time window. The agricultural processing time window signal may be usable to be transmitted to an agricultural device such as a robot. The agricultural device such as the robot may be configured for performing agricultural processing within the agricultural processing time window based on the agricultural processing time window signal and/or within the safe time window based on the safe time window signal.

The database may include several data layers. One of the data layers may include geographical information of the agricultural zone and the animal protection zone. For example, the geographical information may be included in a look-up-table (LUT) and/or in image data, such as a high-resolution map with marked zones. The image data may include, for example, border coordinates of the zones as well as the zones, such as fields in which agricultural processing is to be performed, water bodies, forests, animal habitats, or the like. The database may also include a data layer in which information about the animal life-cycle of the animal species, such as historic data about the animal life-cycle, is stored. Furthermore, one of the data layers of the database may include crop phenology as well as historic data about the growth of different crops. The database may also include in one data layer, the weather data, e.g., current weather data, forecasted weather data, and/or historic weather data. The data layers of the database may be used by the agricultural system for determining the overlap zone and/or the safe time window during which agricultural processing which may negatively affect the animal species may be performed in the overlap zone with a reduced risk of unacceptably affecting the animal species.

The agricultural system, e.g., a safe time window determination unit, may be configured for determining the safe time window based on the location and the area information of the agricultural zone, the location and the area information of the at least one animal protection zone, the agricultural growth model and/or the animal life-cycle model.

The animal species may in particular be an amphibian species and preferably a toad species.

In a further aspect, a computer-implemented method for protecting an animal species present in an animal protection zone is presented. The computer-implemented method comprises the steps:
- obtaining or generating agricultural zone data indicative of an agricultural zone in which agricultural processing is planned,
- obtaining or generating protection zone data indicative of the animal protection zone that is associated with the animal species present therein,
- providing an animal life-cycle model which is configured for simulating a life-cycle of the animal species,
- determining a life stage of the animal species based on the animal life-cycle model,
- determining an animal protection time window based on the life stage of the animal species during which no agricultural processing which may negatively affect the animal species is to be performed in the animal protection zone in order to protect the animal species,
- determining an overlap zone as a spatial overlap between the agricultural zone and the animal protection zone based on the agricultural zone data and protection zone data, and
- determining a safe time window for an agricultural processing in the overlap zone in dependence on the animal protection time window, the safe time window having no temporal overlap with the animal protection time window.

The computer-implemented method may additionally include one or more of the following steps:
- simulating the life-cycle of the animal species by the animal life-cycle model based on weather data,
- obtaining or generating the weather data based on geographical information of the agricultural zone, or based on a geographical information of the animal protection zone, or based on the geographical location information of the agricultural zone and the geographical information of the animal protection zone,
- determining a likelihood of a presence of the animal species in the overlap zone based on the simulated life-cycle of the animal species,
- determining the safe time window based on the determined likelihood of the presence of the animal species in the agricultural zone,
- providing a safe time window signal based on the determined safe time window,
- providing a safe time window signal usable for controlling an agricultural device such as a robot to perform the agricultural processing in the agricultural zone based on the safe time window signal,
- causing an agricultural device such as a robot to perform the agricultural processing in the agricultural zone based on the safe time window signal,
- performing the agricultural processing in the overlap zone during the safe time window,
- adapting the agricultural processing in the agricultural zone such that no agricultural processing is performed in the overlap zone during the animal protection time window,
- obtaining a growth stage of a crop growing or to be grown in the agricultural zone,
- performing the agricultural processing in the overlap zone during the safe time window in dependence on the obtained growth stage of the crops,
- determining an agricultural processing time window based on the growth stage of the crop, the agricultural processing time window indicating a time range in which agricultural processing is to be performed in the agricultural zone.

The step of obtaining a growth stage of a crop growing or to be grown in the agricultural zone may include one of the steps:
- obtaining or receiving or generating a growth stage of a crop growing or to be grown in the agricultural zone based on user input, or
- determining the growth stage of the crop based on an agricultural growth model configured for simulating the growth of the crop.

The method may additionally include the steps:
- adapting the agricultural processing in the agricultural zone such that agricultural processing performed in the overlap zone during the animal protection time window is less negatively affecting the animal species or does not unacceptably affect the animal species,
- obtaining or receiving the weather data based on geographical information of the agricultural zone, the geographical information of the animal protection zone, or the geographical information of the agricultural zone and the geographical information of the animal protection zone,
- providing an agricultural processing time window signal,
- adapting the agricultural processing in the agricultural zone such that agricultural processing performed in the overlap zone during the animal protection time window is less negatively affecting the animal species or does not unacceptably affect the animal species.

In a further aspect, a computer program product for protecting an animal species is presented. The computer program product comprises program code means for causing a processor to carry out the computer-implemented method according to claim 12 or 13, or any embodiment of the method, when the computer program product is run on the processor.

In another aspect, a computer-readable medium having stored the computer program product according to claim 14 or any embodiment of the computer program product is presented.

It shall be understood that the agricultural system of claim 1, the computer-implemented method of claim 12, the computer program product of claim 14, and the computer-readable medium of claim 15 have similar and/or identical preferred embodiments, in particular, as defined in the dependent claims.

It shall be understood that a preferred embodiment of the present invention may also be any combination of the dependent claims or above embodiments with the respective independent claim.

These and other aspects of the invention will be apparent from and elucidated with reference to the embodiments described hereinafter.

### BRIEF DESCRIPTION OF THE DRAWINGS

In the following drawings:
- Fig. 1: schematically shows an embodiment of an agricultural system in form of an animal protection tool for protecting an animal species,
- Fig. 2: exemplary and schematically shows an agricultural zone and animal protection zone that are highlighted in a section of a topographic map,
- Fig. 3: schematically and exemplary shows time ranges of a safe time window, an animal protection time window, an agricultural processing time window, and a preferred time window for performing agricultural processing,
- Fig. 4: exemplarily and schematically shows a year-round life-cycle of amphibians for the example of common toads,
- Fig. 5: exemplary and schematically shows year-round movements of common toads,
- Fig. 6A: schematically shows migration of common toads to certain distances from a water body for different life stages,
- Fig. 6B: exemplarily shows cumulative distributions of the common toads around the water body at different life stages indicating probabilities for the presence of the animal species in an overlap zone between an animal protection zone and an agricultural zone,
- Fig. 7: shows an agricultural zone and an animal protection zone highlighted in a topographic map,
- Fig. 8: shows another topographic map with an agricultural zone and an animal protection zone,
- Fig. 9: shows a topographic map with an agricultural zone and two animal protection sub zones forming an animal protection zone spatially overlapping with the agricultural zone,
- Fig. 10: schematically shows amphibian annual life phases for eleven subsequent years,
- Fig. 11: schematically shows three data layers used by the agricultural system of Fig. 1 for determining a safe time window for performing agricultural processing,
- Fig. 12: shows a schematic and exemplary flow diagram of an embodiment of a computer-implemented method for protecting an animal species present in an animal protection zone,
- Fig. 13: shows a graphical user interface image showing a digital map of a certain area recorded as a satellite image and an input mask for inputting details of an intended application of a chemical product on a selected crop field,
- Fig. 14: shows a subsequent graphical user interface image depicting different growth stages of winter wheat for several different dates during a year,
- Fig. 15: shows a subsequent graphical user interface image for providing information of when to apply the chemical product for a selected date for intended chemical product application,
- Fig. 16: shows a subsequent graphical user interface image for providing information of when to apply the chemical product for another selected date intended chemical product application,
- Fig. 17: shows a subsequent graphical user interface image including crop interception and soil load information,
- Fig. 18: shows a subsequent graphical user interface image with a lowered intended application rate, and
- Fig.19: shows a further subsequent graphical user interface image.

### DETAILED DESCRIPTION OF EMBODIMENTS

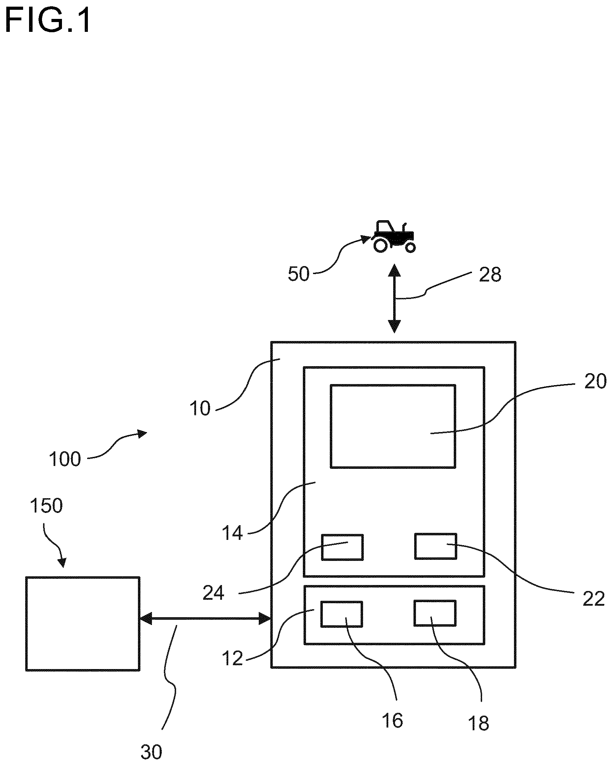

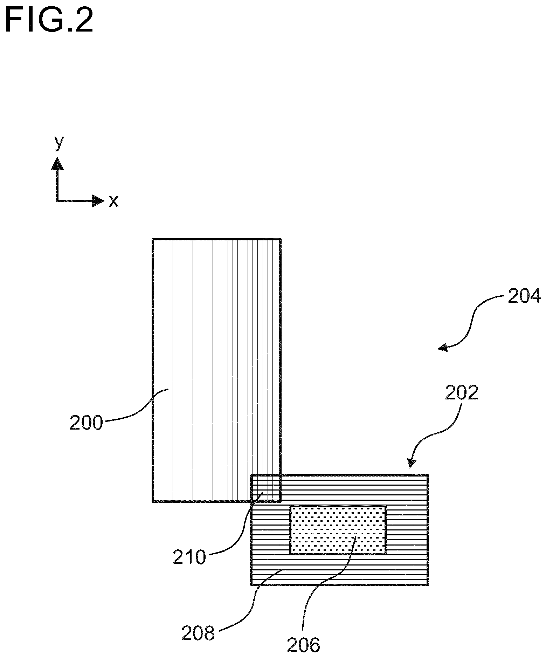

Fig. 1 schematically shows an embodiment of an agricultural system 100 in form of an animal protection tool for protecting an animal species that is present in an animal protection zone 202 (cf. Fig. 2). In this embodiment, the agricultural system 100 may be used for protecting an amphibian species, in particular a toad species, namely common toads.

The agricultural system 100 comprises a portable electronic device 10 such as a mobile phone or a tablet computer. Furthermore, in this embodiment, the agricultural system 100 additionally includes an agricultural device, which is a robot 50, for example, a tractor or a drone, which may perform agricultural processing, e.g., based on control signals received from the electronic device 10. In other embodiments, the robot 50 may also be external to the agricultural system 100. The agricultural system 100 is connected to an external server 150 in form of a weather station. In other embodiments, the agricultural system may also include one or more servers, such as weather stations or weather satellites.

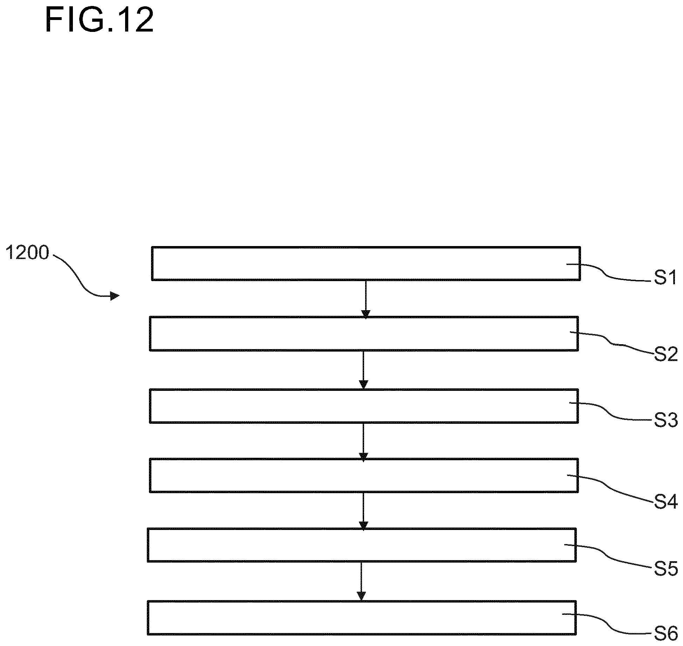

The electronic device 10 comprises a control unit 12 and a communication interface 14. The control unit 12 has a processor 16 and a computer readable medium in form of a memory component 18. The processor 16 processes data and performs calculations. The memory component 18 stores the data such as agricultural zone data and/or protection zone data and/or weather data. The memory component 18 may furthermore store a computer program product for protecting the animal species. The computer program product comprises program code means for causing the processor 16 to carry out a computer-implemented method for protecting the animal species, e.g., the embodiment of the computer-implemented method disclosed in Fig. 12, when the computer program product is run on the processor 16. The memory component may store further programs for operating the electronic device 10 using processor 16.

The communication interface 14 comprises a user interface in form of a touch display 20, a transceiver 22 and an antenna array 24. The communication interface 14 is used for communicating, e.g., with the user or other devices or servers. The touch display 20 visualises content to a user and allows the user to interact with the electronic device 10, e.g., by providing user input. The transceiver 22 and the antenna array 24 are used for exchanging data between the electronic device 10, the robot 50, and the external server 150. In order to exchange data with the robot 50, a data link 28 may be established by the transceiver 22 via the antenna array 24. Furthermore, for exchanging data with the external server 150, the transceiver 22 may establish a data link 30 via the antenna array 24.

In the following, the functionality of the agricultural system 100 for protecting amphibians and in particular common toads is described with respect to Fig. 1, Fig. 2, and Fig. 3. In particular, the agricultural system 100 is used as an animal protection tool which determines a number of favourable days when agricultural processing which may negatively affect the animal species may be performed in an agricultural zone 200 in form of a crop field (cf. Fig. 2) without unacceptably affecting the animal species. In particular, the agricultural system 100 is used for determining when a chemical product, such as a fungicide may be applied in the agricultural zone 200 without unacceptably affecting metamorphs of the common toads present in a part of the agricultural zone 200, namely in an overlap zone 210 formed by a spatial overlap between the agricultural zone 200 and the animal protection zone 202.

In this embodiment, the memory component 18 stores image data representing a topographic map 204 of earth or at least part of earth (cf. Fig. 2). The topographic map 204 or at least sections of this topographic map 204 may be visualised on the touch display 20.

The user may provide geographical information about the agricultural zone 200 in which the user wants to perform agricultural processing as input to the electronic device 10 via the touch display 20. For example, the user may input a location in form of a location name into a text field based on which the agricultural system generates agricultural zone data. Alternatively, or additionally, the user may input geographical coordinates, such as latitude and longitude, and/or the user may input the location by any other means for identifying a location on the topographic map 204, e.g., clicking on the location and zooming into the topographic map 204 based on which the agricultural system generates agricultural zone data. The electronic device 10 associates the location name with a specific location within the topographic map 204 and shows the location and an environment surrounding the location via the touch display 20, e.g., employing generated agricultural zone data.

The user may then select a zone as the agricultural zone 200 in the displayed location and its environment in the topographic map 204. For example, the user may select boundaries of the agricultural zone 200 by touching points on the topographic map 204 displayed on the touch display 20 which serve as boundaries to the agricultural zone 200 and based on which the agricultural system generates agricultural zone data. Alternatively, the boundaries may be automatically determined by the agricultural system 100 based on image recognition, e.g., by automatically detecting the agricultural zone 200 or several agricultural zones based on zone specific features. The agricultural system 100 then generates corresponding agricultural zone data.

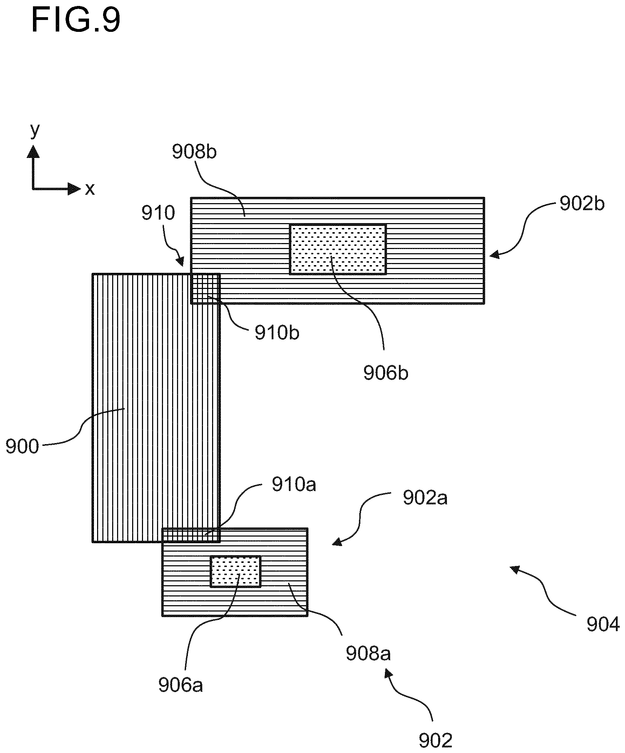

Furthermore, the animal protection zone 202 or multiple animal protection zones (cf. Fig. 9) may be automatically determined in the environment of the agricultural zone 200. In this embodiment, animal protection zones are determined based on information contained in protection zone data from a database stored on the external server 150. In other embodiments, the database comprising protection zone data may also be included in the agricultural system 100. In yet other embodiments, the animal protection zones may be determined based on image recognition to generate corresponding protection zone data.

In this embodiment, the database includes geographical information about water bodies. The electronic device 10 receives this information for the environment of the agricultural zone 200 displayed on the touch display 20. In particular, Fig. 2 shows a water body 206 in the environment of the agricultural zone 200. Furthermore, in this embodiment, processor 16 automatically determines a zone 208 around the water body 206. The surrounding zone 208 together form the animal protection zone 202. The animal species, here the common toads, are present in the animal protection zone 202 during a certain life stage of their life-cycle. The zone 208, in this embodiment, is determined by using the boundaries of the water body 206 and extending them by an extension of 290 m in each direction. The extension of the surrounding zone may depend on the animal species present in the water body.

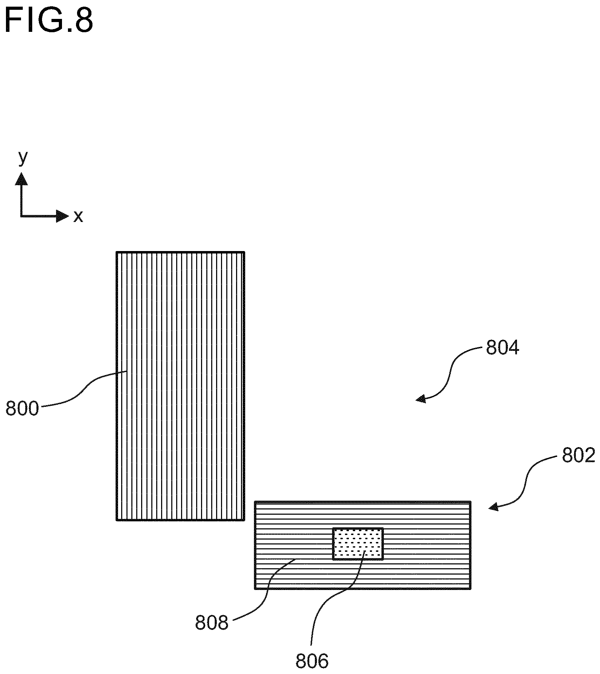

The processor 16 then determines the overlap zone 210 based on a spatial overlap between the agricultural zone 200 and the animal protection zone 202. In this embodiment, geographical coordinates of the boundaries of the agricultural zone 200 represented by agricultural zone data and the animal protection zone 202 represented by protection zone data are compared in order to determine whether they overlap. In the scenario of the topographic map 204 in Fig. 2, it is determined that the top left corner of the animal protection zone 202 is within the agricultural zone 200. In other embodiments, other geographical coordinates may be used for determining whether there is a spatial overlap between the agricultural zone 200 and the animal protection zone 202. In case, there is no spatial overlap between the agricultural zone and the animal protection zone (cf. Fig. 8), agricultural processing may be performed at any time in the agricultural zone without negatively affecting the animal species, as the animal species will not be in the agricultural zone during a life stage when the animal species is vulnerable to the agricultural processing.

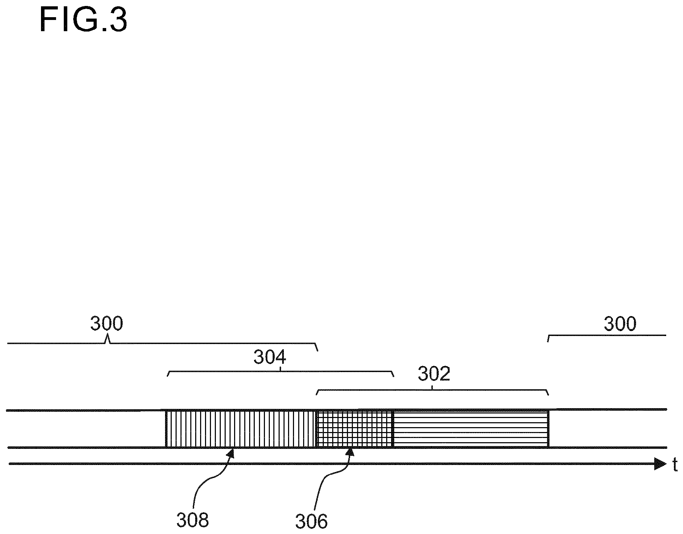

However, since in the scenario in Fig. 2, a spatial overlap of the agricultural zone 200 and the animal protection zone 202 are determined in form of the overlap zone 210, the animal species may be negatively affected within the overlap zone 210 during an animal protection time window 302 (cf. Fig. 3). The animal protection time window 302 corresponds to a time range during which the metamorphs of the common toads are present in the animal protection zone 202 and in particular in the overlap zone 210 and may be affected by agricultural processing which may negatively affect the animal species. Therefore, the agricultural system 100 determines when the animal species needs to be protected in the overlap zone 210, i.e., during the animal protection time window 302, and when it is safe to perform agricultural processing which may negatively affect the animal species, namely, during a safe time window 300.

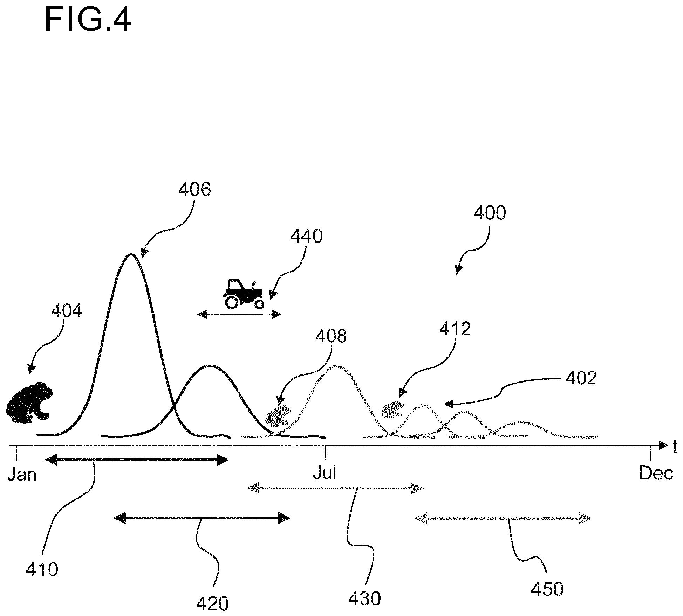

In order to determine the safe time window 300, the processor 16 first determines a life stage of the animal species, in particular, here the life stage of the common toads, present in the animal protection zone 202 based on an animal life-cycle model which is configured for simulating a life-cycle of the animal species. Details regarding the determination of the life stage of the animal species and the animal life-cycle model will be provided with respect to the description of Figs. 4 to 6 below.

Then, the animal protection time window 302 is determined based on the life stage of the animal species. In other embodiments, further parameters may be considered, such as the interception which is characterized as the relative quantity of a chemical product that does not reach the soil surface, which reduces the exposure of the animal species in the agricultural zone. In fact, the growth stage of a certain crop determines the interception and the interception, in turn, determines the soil load. The larger the interception is, the smaller is the soil load. A large interception is thus beneficial to be able to still apply a chemical product in an overlap zone without negatively affecting an animal species potentially present therein. This may lead to a situation in which a chemical product may still be applied in an overlap zone although a to-be-protected animal species is potentially present therein because since the interception is high enough to provide a sufficiently low soil load.

Accordingly, the life stage at which the agricultural processing does not unacceptably affect the animal species may be influenced by the crop interception. This may allow to shorten the animal protection time window 302. During the animal protection time window 302, the animal species is expected to be present as metamorphs in the overlap zone 210 according to the life stage determined from the animal life-cycle model. The metamorphs may be negatively affected by the agricultural processing. Hence, no agricultural processing which may negatively affect the animal species is to be performed in the animal protection zone 202 and in particular in the overlap zone 210 during the animal protection time window 302 in order to protect the animal species. Agricultural processing which may negatively affect the animal species may thus be performed in the agricultural zone 200 except from the overlap zone 210. Still agricultural processing with adapted agricultural processing parameters may be performed within the overlap zone if it will not negatively affect the metamorphs present in the overlap zone. Accordingly, the agricultural processing may be adapted such that it does not unacceptably affect the animal species in the overlap zone 210, e.g., by reducing the amount of a chemical product, an application pattern, an application rate, or by applying another chemical product which is less negatively affecting the animal species, or by any other adaption which may reduce the impact on the animal species in the overlap zone. In this case, the adapted agricultural processing may still be performed in the overlap zone 210 while any agricultural processing may be performed in the rest of the agricultural zone 200.

In this embodiment, the safe time window 300 is then defined as the time range, which does not temporally overlap with the animal protection time window 302 (cf. Fig. 3). In other embodiments, the safe time window 300 for agricultural processing in the overlap zone 210 may also be determined in dependence on the animal protection time window 302 in any other manner, such that the safe time window 300 does not have a temporal overlap with the animal protection time window 302.

Fig. 3 discloses a section of a year including different time ranges, in particular, the animal protection time window 302 and an agricultural processing time window 304. The agricultural processing time window 304 corresponds to a time range during which agricultural processing should be performed. For instance, there may be a high pest pressure during the agricultural processing time window 304 and it may be beneficial to apply plant protection products during that time range in order to control the pests. Applying plant protection products or other chemical products may negatively affect the animal species, in particular, the metamorphs of the common toads, in the overlap zone 210 during the animal protection time window 302. Hence, no agricultural processing which may negatively affect the animal species should be performed during an overlap time window 306, which is determined as a temporal overlap of the agricultural processing time window 304 and the animal protection time window 302. The overlap time window 306 is not within the safe time window 300. The agricultural processing, in this case, applying plant protection products, may, however, be performed during a preferred time window 308. The preferred time window 308 is within the agricultural processing time window 304 and within the safe time window 300 or in other words, the preferred time window 308 is formed as temporal overlap of the safe time window 300 and the agricultural processing time window 304. Performing the agricultural processing during the preferred time window 308 allows an improved agricultural processing while protecting animal species in the overlap zone 210. The preferred time window 308 may also be considered as a safe time window, namely, a safe time window determined based on the animal protection time window and the agricultural processing time window.

The agricultural processing time window 304 may be determined based on a growth stage of a crop growing or to be grown in the agricultural zone 200. In order to determine the agricultural processing time window 304, the growth stage of the crop needs to be obtained. The growth stage of the crop may be determined using an agricultural growth model configured for simulating the growth of the crop. In particular, the user may input a crop type and a planting date and the agricultural growth model may determine the growth stage of the crop over time. The agricultural growth model may determine the growth stage of the crop based on further environmental parameters, for example, based on weather data, such as precipitation, temperature, and humidity. The growth stage of the crop may be, for example, a BBCH value. The growth stage of the crop may be used to determine when certain agricultural processing is to be performed or in other words, the agricultural processing time window 304 may be determined in dependence on the growth stage of the crop. Alternatively, the growth stage of the crop may also be received as input by the user, e.g., in form of a BBCH value.

The determined growth stage of the crop may also be used for determining a crop interception. The larger the crop growths the more is the crop typically covering the ground. As a result, with the crop growing larger, a reduced amount of a chemical product will reach the soil since a large fraction of the applied chemical product is hindered by the crop to reach the ground. As a result, the crop interception is large. Since only a reduced amount of the chemical product actually reaches the soil, the risk for an animal species potentially present on the soil to get unacceptably affected may be further reduced. This may allow to nevertheless apply a chemical product on the crop although a to-be-protected animal species may potentially be present in the overlap zone. By taking into account the growth stage of crop, it is therefore possible to more accurately determine the animal protection time window during which agricultural processing may be performed in the overlap zone. For example, when taking into account the growth stage of the crop for determining the animal protection time window, the animal protection time window may include a comparatively smaller time duration compared to an animal protection time window that is determined without considering the growth stage of a crop. As a result, the safe time window may include a comparatively larger time duration since the resulting soil load may be low enough, i.e., below a predefined ecotoxicological threshold, such that agricultural processing can be performed within the overlap zone without negatively affecting an animal species that is potentially present in the overlap zone.

The electronic device 10 then generates a safe time window signal based on the determined safe time window 300. In this embodiment, the safe time window signal is a control signal usable for controlling the operation of the robot 50. In other embodiments, the safe time window signal may also be an information signal, e.g., a display signal, usable for providing information about the safe time window 300 to the user. The safe time window signal in form of the information signal may, for example, be usable for being displayed via the touch display 20 to the user in order to provide him with the knowledge, during which days agricultural processing which may negatively affect the animal species may be performed without risking unacceptably affecting the animals in the overlap zone 210. In other embodiments, additionally, or alternatively, an agricultural processing time window signal and/or an animal protection time window signal may be generated. The robot 50 may be controlled based on these signals or information about the agricultural processing time window and/or the animal protection time window may be displayed to the user.

In this embodiment, the robot 50 performs agricultural processing in the agricultural zone 200, and in particular, the overlap zone 210, based on the safe time window signal. In particular, the robot 50 performs agricultural processing which may negatively affect the animal species in the overlap zone 210 during the safe time window 300. In other embodiments, the robot 50 may perform an adapted agricultural processing in the agricultural zone 200 such that no agricultural processing is performed in the overlap zone 210 during the animal protection time window 302. In other words, in this case agricultural processing which may negatively affect the animal species is performed in the agricultural zone 200 except for the overlap zone 210 in which no agricultural processing is performed. In yet other embodiments, an adapted agricultural processing may also be performed in the overlap zone 210 during the animal protection time window 302 which does not unacceptably affect the animal species, e.g., by changing the applied chemical product or lowering its concentration.

In further embodiments, the agricultural system 100 may be configured for performing the agricultural processing in the overlap zone 210 during the safe time window 300 in dependence on the growth stage of the crop.

Since the agricultural system 100 allows determining the safe time window 300 during which agricultural processing may be performed without risking unacceptably affecting the amphibians, no search for animals in the agricultural zone 200 and particularly in the overlap zone 210 is required for protecting the animal species. Furthermore, agricultural processing may be performed during the agricultural processing time window, i.e., during a time when agricultural processing is beneficial, e.g., in order to increase yield of the crop of the agricultural zone.

In other embodiments, more than one animal species may be considered for determining the safe time window. In this case, different safe time sub-windows may be determined for the individual animal species and a temporal overlapping time range may be used as safe time window, which allows protecting all the animal species.

The animal life-cycle model is described in the following with respect to Fig. 4, Fig. 5, and Fig. 6. The animal life-cycle model is used by the agricultural system 100 for determining the life stage of the animal species. In this embodiment, the animal life-cycle model is configured for simulating the life-cycle of the animal species based on weather data. This embodiment relates to common toads. Other embodiments include other animal species, in particular amphibian species. Furthermore, in this embodiment, the animal life-cycle model is a statistical model, which determines spatio temporal scores indicating the likelihood of the presence of the animal species in the agricultural zone 200, in particular, in the overlap zone 210, based on the life stage of the animal species (cf. Fig. 2).

The agricultural system 100 receives weather data from weather stations monitoring the weather in or close to the animal protection zone 202 and the agricultural zone 200. For example, weather data may be received via the datalink 30 from a database stored in the external server 150. The weather data may then be stored in the memory component 18 for further processing by the processor 16. In other embodiments, the agricultural system 100 may also be configured for obtaining the weather data based on geographical information of the agricultural zone 200, or based on a geographical information of the animal protection zone 202, or based on the geographical location information of the agricultural zone 200 and the geographical information of the animal protection zone 202.

The weather data may include a temperature profile of soil temperature, e.g., in a depth of 10 cm, and an air temperature. The weather data may, for example, include historic data over the past two years. Alternatively, or additionally, the weather data may include a weather forecast in form of a temperature profile of soil temperature and air temperature that is to be expected, for example, within the next ten days. Alternatively, or additionally, the weather data may include a precipitation profile representing an amount of precipitation measured during the last two years and/or some future time range, for example, the upcoming ten days, as a weather forecast.

The life stage of the animal species may be related to the weather data since soil temperature and air temperature as well as amount of precipitation influence each of the life stages of the animal species. For example, toad metamorphs may leave their natal pond only if certain soil temperature and air temperatures are maintained for several days. In addition, there needs to be a certain amount of precipitation during these days to allow the toad metamorphs to leave their natal pond.

In this embodiment, the agricultural system 100 uses the weather data and the animal life-cycle model for determining the likelihood of the presence of the animal species, here, the common toads, in the overlap zone 210 based on the simulated life-cycle of the animal species.

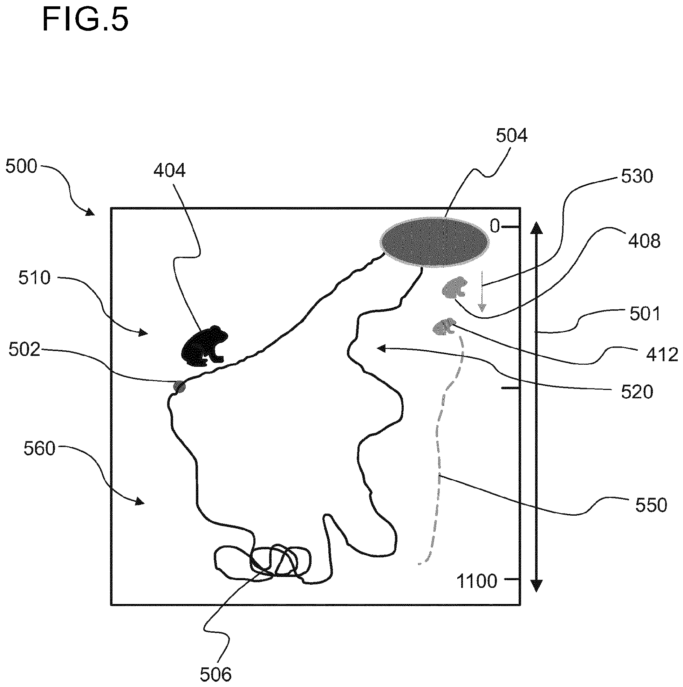

Fig. 4 schematically shows a year-round life-cycle 400 of common toads 402 from January to December with various life stages, namely adult toads 404, toad metamorphs 408, and toad juveniles 412 of the common toads 402. Fig. 5 schematically shows year-round movements or migrations, respectively of the common toads 402 in a topographic map 500 with a schematic distance indication 501. In Fig. 4, probability distributions 406 for the respective migrations of the common toads 402 are shown which indicate a probability for the common toads 402 to migrate at a certain point of time in the year. The probability distributions 406 depend on the weather data, in particular, soil temperature, air temperature, and precipitation.

Typically starting in March, adult toads 404 start their spring migration 510 from their winter habitat 502 to a breeding pond 504 during a spring migration period 410 (cf. Fig. 4 and Fig. 5). Once at the breeding pond 504, the adult toads 404 lay their eggs into the breeding pond 504, e.g., typically in April.

Subsequently, the adult toads 404 start their summer migration 520 from the breeding pond 504 to their summer habitat 506 in a summer migration period 420.

Meanwhile the next toad generation is growing in the breeding pond 504. After they become metamorphs 408, the metamorphs 408 start their emigration 530 from the breeding pond 504 into the zone around the breeding pond 504 during a metamorph emigration period 430. Common toad metamorphs 408 emigrate up to a distance of approximately 290 m from the breeding pond 504. The metamorph emigration period 430 may overlap with an agricultural processing time window 440 during which agricultural processing may be beneficially performed in agricultural zones, which may overlap with the zone, where metamorphs are present. Therefore, the common toad metamorphs 408 may need to be protected during their emigration period 430, which may correspond to an animal protection time window. Namely, in case that the zone around the breeding pond 504 overlaps with the agricultural zone, performing agricultural processing during the emigration period 430 may negatively affect the common toads.

Later in the year, after their metamorphosis is completed, typically, after the 20^{th} June, the metamorphs 408 have grown up to juvenile toads 412. The juvenile toads 412 start migrating to their winter habitats 502 in another migration 550 during an autumn migration period 450. The adult toads 404 also migrate to their winter habitats 502 in their autumn migration 560.

In the winter habitat, the common toads 402 remain in hibernation until the yearly life-cycle repeats in the next year with their spring migration 510 to the breeding pond 504 during the spring migration period 410.

The animal life-cycle model simulates the life-cycle of the animal species based on the aforementioned understanding of the life-cycle of amphibians presented for the example of common toads. The animal life-cycle model further considers the likelihood or probability, respectively, of a presence of the animal species in the overlap zone based on their likelihood of migration to certain distances from the breeding pond 504.

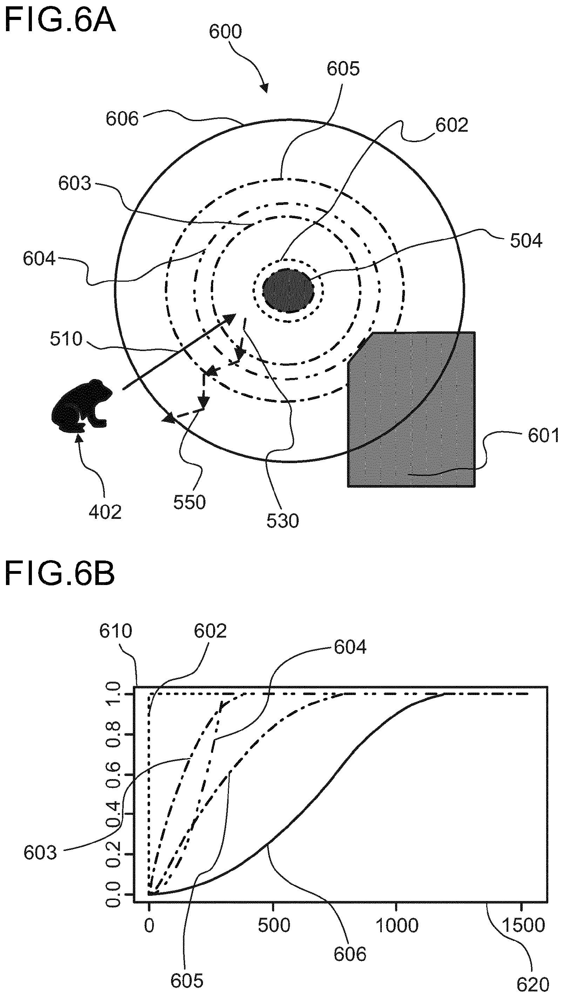

Fig. 6A schematically shows a topographic map 600 indicating distributions 602, 603, 604, 605, and 606 of common toads 402 at different life stages in certain distances from the breeding pond 504 during different migration periods. Fig. 6B exemplarily shows on the vertical axis a cumulative distribution 610 and on the horizontal axis a distance 620 of the common toads 402 at different life stages from the breeding pond 504. Different distributions 602, 603, 604, 605, and 606 are shown for different migration periods. The cumulative distributions of the distance of the common toads 402 from the breeding pond 504 indicate probabilities for the presence of the animal species, here, the common toads, in an overlap zone between an animal protection zone and an agricultural zone 601.

The common toads 402 move into the breeding pond 504 during the spring migration 510, such that they are within the breeding pond 504 for laying their eggs. In particular, distribution 602 indicates that the adult toads 404 are within the breeding pond 504 with its bank defined at a distance of zero. Subsequently, the adult toads 404 migrate to their summer habitat 506 in their summer migration 520, which is indicated with distribution 606 (cf. Fig. 5, Fig. 6A, and Fig. 6B). Distribution 606, for example, shows that only about 20 percent of the adult toads 404 are expected to be present within a 500 m radius of the breeding pond 504, while essentially 100 % of the adult toads 404 are expected to be within a 1500 m radius of the breeding pond 504.

Meanwhile from the eggs metamorphs 408 are growing. The metamorphs 408 move from the breeding pond 504 into the zone around the breeding pond 504 in an emigration 530 during the emigration period 430, which is indicated by distribution 603. According to distribution 603, essentially 100 % of the metamorphs 408 stay within a 290 m radius of the breeding pond 504.

Over time, the metamorphs 408 grow into juveniles 412. The juveniles 412 start moving to further distances indicated by distribution 605 until they finally move to their winter habitat 506 for hibernating.

The animal life-cycle model is used for determining the life stage of the animal species in order to determine the likelihood of the presence of the animal species in the overlap zone 210. The agricultural system 100 then eventually determines the safe time window 300 based on the determined likelihood of the presence of the animal species in the overlap zone 210.

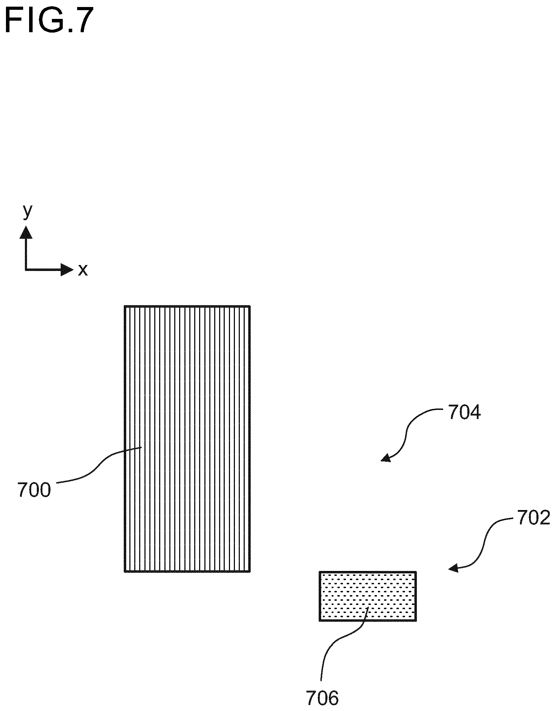

In the following, different scenarios of spatially overlapping or non-overlapping agricultural zones and animal protection zones are presented in topographic maps 704, 804, and 904 with respect to Fig. 7, Fig. 8, and Fig. 9.

Fig. 7 shows a scenario with an agricultural zone 700 in form of a crop field and an animal protection zone 702 including a water body 706 highlighted in the topographic map 704. The topographic map 704 may be displayed, for example, on a display, e.g., on the touch display 20 of the agricultural system 100 shown in Fig. 1. In this embodiment, the agricultural zone 702 does not include a protection zone since the animal species that is to be protected is only present in the water body 706. Furthermore, the agricultural zone 700 does not spatially overlap with the animal protection zone 702. Therefore, any agricultural processing may be performed in the agricultural zone 700 at any time without risk of negatively affecting the animal species present in the animal protection zone 702.

Fig. 8 shows another scenario with an agricultural zone 800 in form of a crop field and an animal protection zone 802 including a water body 806 and a zone 808 surrounding the water body 806. The size of zone 808 depends on the animal species, e.g., a frog species, present in the animal protection zone 802 that is to be protected. In this embodiment, the animal protection zone 802 and the agricultural zone 800 do not spatially overlap. Hence, also in this scenario, any agricultural processing may be performed in the agricultural zone 800 at any time without risk of negatively affecting the animal species present in the animal protection zone 802.

Fig. 9 shows yet another scenario with an agricultural zone 900 in form of a crop field and an animal protection zone 902 formed by two animal protection sub zones 902a and 902b. Each of the animal protection zones 902a and 902b is formed by a respective water body 906a and 906b, respectively, and a respective zone 908a and 908b, respectively. The animal protection zone 902 spatially overlaps with the agricultural zone 900 in the overlap sub zones 910a and 910b. The overlap sub-zones 910a and 910b form an overlap zone 910 in which the animal species needs to be protected from agricultural processing. For example, the agricultural system 100 presented in Fig. 1 may be used for determining a safe time window 300 during which agricultural processing may be performed in the overlap zone 910.

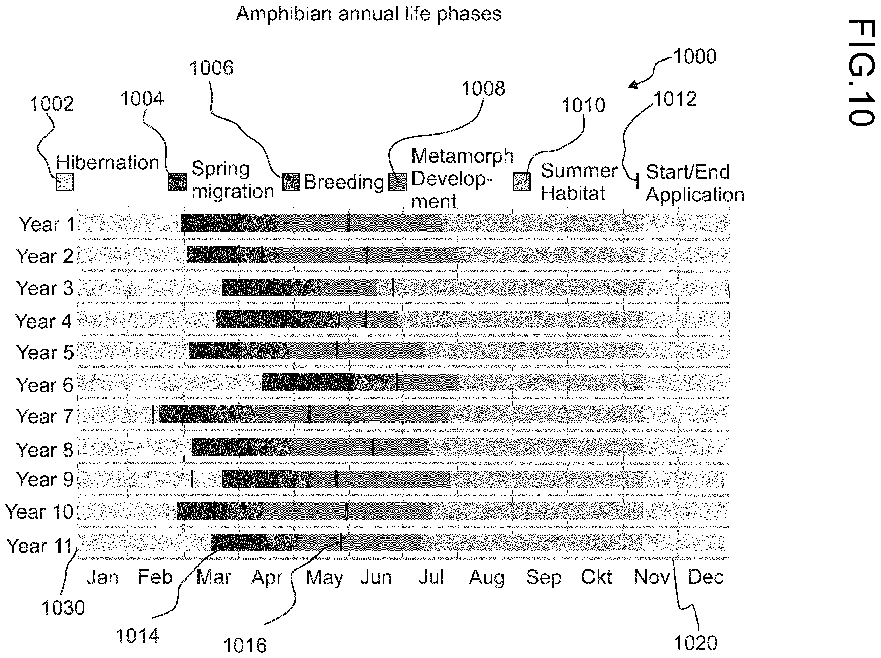

Fig. 10 schematically shows amphibian annual life phases 1000 for eleven subsequent years Year 1 up to Year 11. The horizontal-axis 1020 represents the months of the year whereas the vertical-axis 1030 represents the respective year. For each year, the different life-cycle phases are represented by the same colour code such that a shift in time for a specific life-cycle phases can be observed from year to year.

As can be seen from the colour code, the different life-cycle phases comprising hibernation 1002, spring migration 1004, breeding 1006, metamorph development 1008, and summer habitat 1010 are shifted in time from year to year. These shifts may be caused by different weather conditions such as different soil temperature, different air temperature, and different precipitation. Specific weather conditions may influence or trigger some of the different life-cycle stages 1002, 1004, 1006, 1008, 1010. The historic data may be considered in the animal-life cycle model for simulating the life-cycle of the animal species.

The crop phenology, in general, also strongly depends on weather conditions. Accordingly, the agricultural processing time window also shifts from year to year in dependence on the weather conditions. The agricultural processing time window is indicated by solid vertical black lines 1012. In each year a start 1014 and an end 1016 of the agricultural processing time window is indicated.

Knowing the agricultural processing time window during which agricultural processing is beneficial for improving the yield of crop grown in an agricultural zone allows selecting a time for agricultural processing in dependence on the life stage of the animal species such that yield may be increased without negatively affecting the animal species. It is preferred to perform agricultural processing either when the animal species has left the animal protection zone to migrate to, e.g., their winter habitat or when the adults have left the animal protection zone after egg-laying and the young metamorphs have not yet dispersed into a zone surrounding their natal pond.

Thus, a time range, i.e., a preferred time window 308 for agricultural processing may be determined that is shared by the agricultural processing time window 304 and the safe time window 300, e.g., as determined with the agricultural system 100 described with reference to Fig. 1, Fig. 2, and Fig. 3.

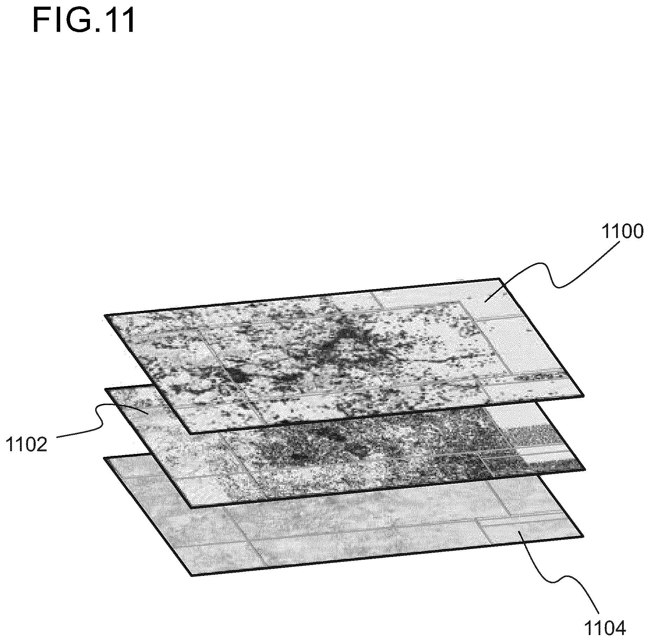

Fig. 11 schematically shows three data layers that may be used by the agricultural system 100 as described with reference to Fig. 1, Fig. 2, and Fig. 3 for determining the safe time window 300. A first data layer 1100 represents a high-resolution map showing amphibian habitats. A second data layer 1102 represents an animal life-cycle model of an animal species. A third data layer 1104 represents a growth model of a crop growing in an agricultural zone in form of a crop field that may spatially overlap with an animal protection zone.

As further input, weather data are preferably used representing air temperature, and soil temperature, and precipitation, for example, representing a ten-day forecast and two years of historical values. For example, a spatial resolution of 12 km or less may be used for the weather data.

Fig. 12 shows a schematic and exemplary flow diagram of an embodiment of a computer-implemented method 1200 for protecting an animal species present in an animal protection zone.

The computer-implemented method 1200 described in the following may be conducted by an agricultural system, e.g., the embodiment of the agricultural system 100 shown in Fig. 1.

In particular, the computer-implemented method 1200 described in the following may be carried out by a computer program product for protecting an animal species running on a processor, e.g., processor 16 of agricultural system 100. The computer program product comprises program code means for causing the processor, e.g., processor 16 of agricultural system 100, to carry out the computer-implemented method.

The computer program product may be stored on a computer-readable medium, e.g., the memory component 18 of the agricultural system 100.

The computer-implemented method may particularly be used for protecting amphibian species, such as toad species, and in particular, common toads, present in an animal protection zone including a water body and a surrounding zone.

In step S1, an overlap zone between an agricultural zone and the animal protection zone is determined based on their spatial overlap. To this end, agricultural zone data indicative of an agricultural zone in which agricultural processing is planned as well as protection zone data indicative of the animal protection zone that is associated with the animal species present therein are processed.

In step S2, a life stage of the common toads is determined based on an animal life-cycle model, which is configured for simulating a life-cycle of the common toads. In this embodiment, the animal life-cycle model is based on the animal life-cycle as described with respect to Figs. 4 to 6.

In particular, in this embodiment, the life-cycle of the common toads is determined by the animal life-cycle model based on weather data. The weather data is received from weather stations in or close by the animal protection zone. In other embodiments, the weather data may also be obtained based on geographical information of the agricultural zone, or based on a geographical information of the animal protection zone, or based on the geographical location information of the agricultural zone and the geographical information of the animal protection zone.

The simulated life-cycle of the common toads is used for determining a likelihood of a presence of the common toads in the overlap zone. In other words, a probability for the common toads to be somewhere in the overlap zone for different time ranges is determined, e.g., in form of a spatio temporal score based on a statistical model.

In step S3, an animal protection time window is determined in dependence on the likelihood of the presence of the common toads in the overlap zone. The animal protection time window corresponds to a time range during which no agricultural processing which may negatively affect the common toads is to be performed in the animal protection zone in order to protect the common toads as they have a likelihood to be present in the overlap zone, in particular, in form of metamorphs, above a threshold likelihood level. In other embodiments, the animal protection time window may also be determined based on the life stage of the animal species in any other manner. Furthermore, for determining the animal protection time window, it is possible to take into account the growth stage of a crop growing or to be grown in the overlap zone. In particular, based on the growth stage of a crop, a crop interception may be determined that is indicative of a relative amount of a chemical product that reaches the soil when being applied on the crop. That is, the larger the crop interception, the lower will be the amount of a chemical product that reaches the soil. Yet, the lower the amount of a chemical product that reaches the soil, the lower is the risk of an animal species of becoming negatively affected by the chemical product. Determining the animal protection time window may thus include determining an exposure of a chemical product to the animal species potentially present in the overlap zone in the animal protection time window based on a determined crop interception, e.g., using a simulated BBCH stage as a basis.

Furthermore, for determining the animal protection time window it is possible to determine the exposure reaching the soil, i.e., the soil load, e.g., based on the determined crop interception. The determined soil load, i.e., the exposure reaching the soil, may be compared to an ecotoxicological threshold.

In case the soil load may be below the ecotoxicological threshold, the respective day is attributed to a safe time window such that agricultural processing will be allowed. Yet, in case the soil load is higher than the ecotoxicological threshold, the respective day may be attributed to the animal protection time window such that no agricultural processing will be performed, or, alternatively, the agricultural processing parameters are adapted such that the soil load is reduced below the ecotoxicological threshold such that agricultural processing may still be performed with the adapted agricultural processing parameters in the overlap zone with the animal species potentially being present therein.

Next to determining for a certain set of agricultural processing parameters whether application of a chemical product in the overlap zone should be performed or not, it is thus possible to determine, which change of the agricultural processing, e.g. a reduction of the concentration or of the applied amount of a chemical substance would be needed to turn the animal protection time window to a safe time window. It is thus possible to determine how to modify the agricultural processing such that the soil load is below the ecotoxicological threshold. The agricultural processing may then be adapted accordingly, such that the agricultural processing may nevertheless be performed with modified agricultural processing parameters achieving an acceptable risk of a chemical substance negatively affecting an animal species which is potentially present in an overlap zone.

In step S4, a safe time window for an agricultural processing in the overlap zone is determined. The safe time window is determined such that it does not have a temporal overlap with the animal protection time window. In other words, the safe time window is determined to be the time range not overlapping with the animal protection time window. Since, in this embodiment, the animal protection time window is determined based on the likelihood of the presence of the common toads in the overlap zone, also the safe time window is determined based on the likelihood of the presence of the common toads in the overlap zone.

Optionally, in step S5, a safe time window signal is provided based on the determined safe time window. The safe time window signal, in this embodiment, is a control signal usable for controlling an agricultural device such as a robot. In particular, the safe time window signal is configured for causing the agricultural device, e.g., the robot, to perform agricultural processing in the agricultural zone, and in particular, in the overlap zone based on the likelihood of the presence of the common toads in the overlap zone. In other embodiments, the safe time window signal may also be an information signal, e.g., a display signal usable for providing information about the safe time window to a user. The user may then adapt the agricultural processing in the agricultural zone based on the safe time window signal.

Furthermore, optionally, in step S6, an agricultural device such as a robot, e.g., a drone or a tractor, is caused to perform agricultural processing in the agricultural zone based on the safe time window signal. In particular, the agricultural processing is adapted based on the safe time window signal. In this embodiment, no agricultural processing is performed in the overlap zone during the animal protection time window or in other words, agricultural processing is performed in the overlap zone only during the safe time window. In other embodiments, the agricultural processing may also be adapted in another manner such that no agricultural processing which may negatively affect the animal species is performed in the overlap zone. For example, the agricultural processing, e.g., application of a chemical product may be adapted for the overlap zone in that another chemical product is applied which does not unacceptably affect the animal species or in that the concentration or amount applied is reduced such that the animal species is not unacceptably affected or at least less negatively affected.

In other embodiments, the order of the steps S1 to S6 may be different. Furthermore, additional steps may be performed in between or after steps S1 to S6.

For example, a growth stage of a crop growing or to be grown in the agricultural zone may be obtained. The growth stage of the crop may be obtained, for example, by receiving it as user input in form of a BBCH value or it may be determined based on an agricultural growth model configured for simulating the growth of the crop. The agricultural processing in the overlap zone may then be performed during the safe time window in dependence on the obtained growth stage of the crops, e.g., during a preferred time window for agricultural processing which increases the yield. An agricultural processing time window may be determined based on the growth stage of the crop. The agricultural processing time window indicates a time range in which agricultural processing is to be performed in the agricultural zone, particularly, in the overlap zone. Preferably, an agricultural processing time window signal is provided, e.g., a control signal or an information signal with information about the agricultural processing time window.

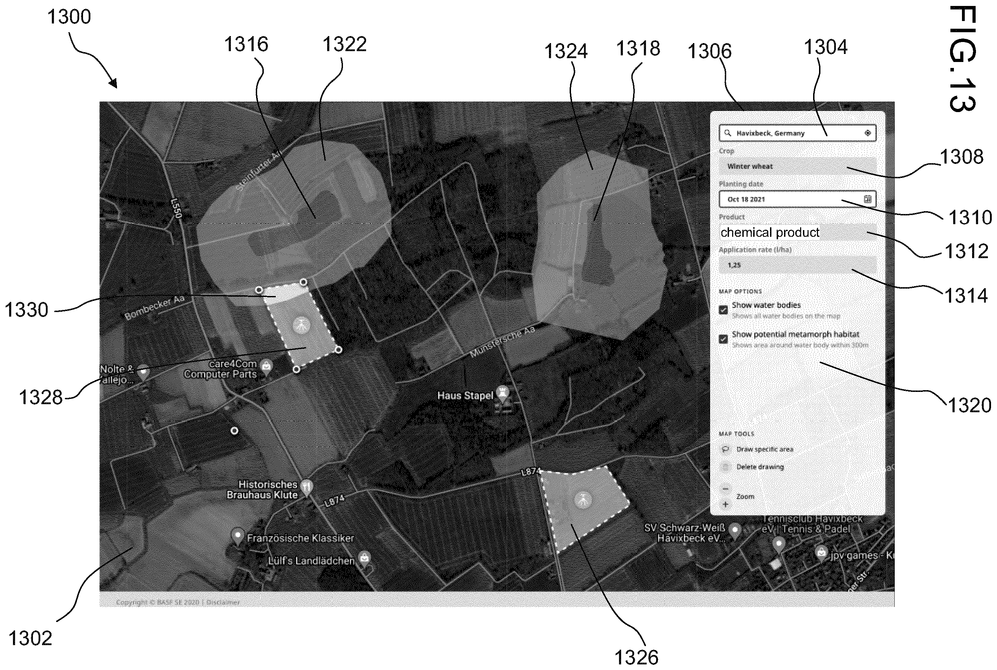

Figs. 13 to 19 shows at the example of subsequent graphical user interface images an exemplary use of an agricultural system, e.g., of any of the agricultural systems described with reference to Figs. 1 to 12.

Fig. 13 shows a graphical user interface image 1300 depicting a digital map 1302 of a certain area recorded as a satellite image. The digital map 1302 shows several crop fields as well as forests, villages and ponds. The specific location shown in the digital map 1302 has been selected upon user input 1304 in an input mask 1306 shown superimposed with the digital map 1302. The input mask 1306 further allows specifying the crop to be planted 1308, which, in this case, is winter wheat. Moreover, a planting date can be selected 1310.

Furthermore, a chemical product 1312 that shall be applied can be selected as well as the application rate 1314 in litre per hectare (l/ha).

The graphical user interface image 1300 allows activating or deactivating several map options 1320 such as to highlight water bodies 1316, 1318 in the digital map 1302 as well as to show potential habitats 1322, 1324 of a to-be-protected animal species, e.g., a metamorph habitat.

In the digital map 1302, two crop fields 1326, 1328 are highlighted. The first crop filed 1326 has no overlap with any potential habitats 1322, 1324 of a to-be-protected animal species. Application of a chemical product in that crop field 1326 can thus be performed at any time without potentially risking an impact on the to-be-protected animal species. Yet, the second crop field 1328 has an overlap zone 1330 with one of the habitats1322, 1324. To reduce the risk of negatively affecting an animal species when performing agricultural processing within the overlap zone 1330, agricultural processing should be performed within a safe time window as determined by the agricultural system.

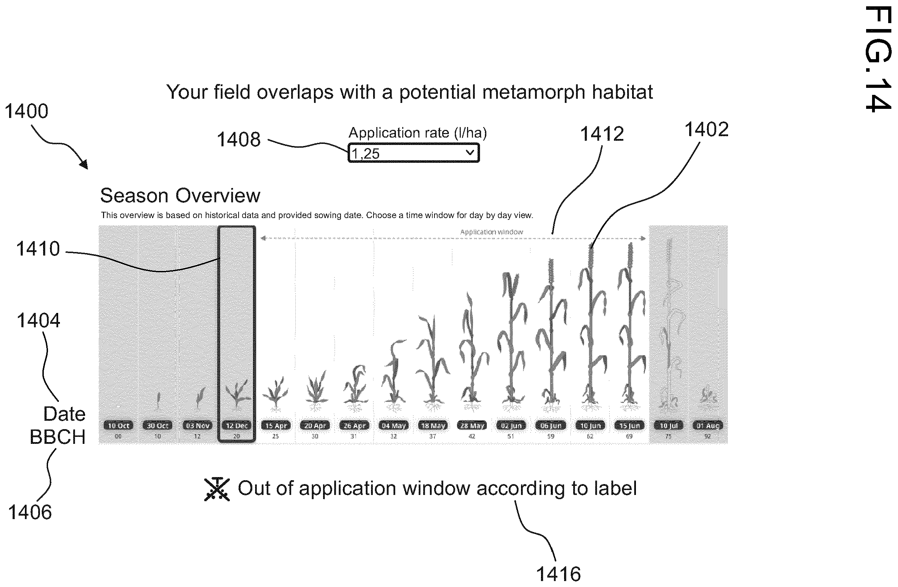

Fig. 14 shows a subsequent graphical user interface image 1400 for providing information of when to apply the chemical product selected in the graphical user interface image 1300 on the second crop field 1328 that has an overlap zone 1330 with the habitat 1322.

The graphical user interface image 1400 schematically depicts different growth stages 1402 of winter wheat for several different dates 1404 during a year. In particular, a growth stage 1402 of winter wheat is depicted for different dates 1404 during a year together with a calculated BBCH value 1406, e.g. determined using an agricultural growth model for winter wheat. Moreover, the application rate 1408 of 1.25 I/ha as selected in the graphical user interface image 1300 is shown. Exemplary, the 12^{th} of December has been selected as indicated by the depicted box 1410. Since the selected date is outside the application window 1412 for winter wheat for the selected chemical product, a corresponding message 1416 may be provided. Accordingly, the agricultural system would perform no agricultural processing in the second crop field 1328 on that selected date.

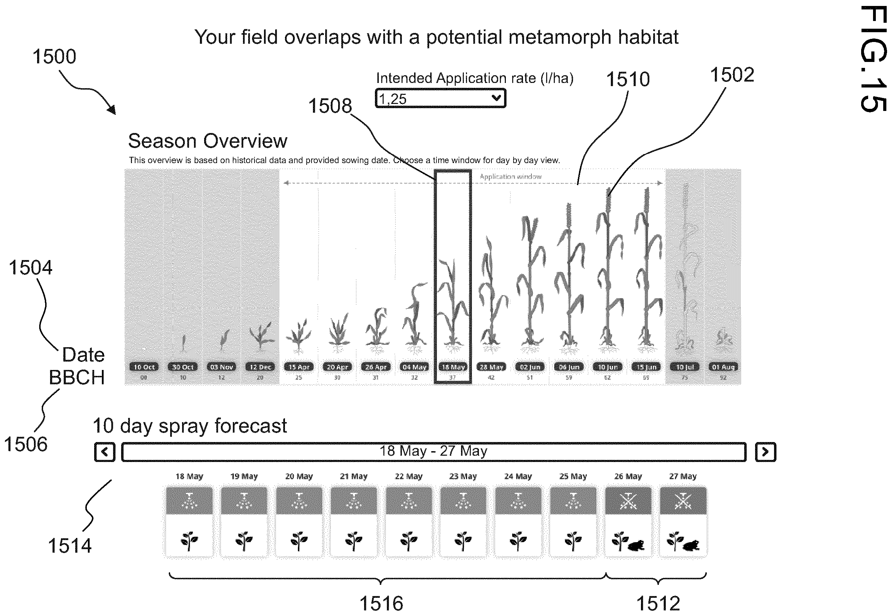

Fig. 15 shows a subsequent graphical user interface image 1500 for providing information of when to apply the chemical product selected in the graphical user interface image 1300 on the second crop field 1328 that has an overlap zone 1330 with the habitat 1322.

The graphical user interface image 1500 shows different growth stages 1502 of winter wheat for several different dates 1504 during a year with corresponding BBCH values 1506 the same way as described with reference to the graphical user interface image 1400. However, in the graphical user interface image 1500, not the 12^{th} of December has been selected as in the graphical user interface image 1400 but the 18^{th} of May as indicated by the box 1508. The 18^{th} of May lies within the application window 1510 for the selected chemical product. Application of the chemical product would thus be in accordance with the growth stage of winter wheat during that time of the year. However, since the second crop field 1328 has an overlap zone 1330 with the habitat 1322 it is additionally determined whether the selected date lies within a determined animal protection time window 1512. To this end, a ten day spray forecast 1514 is visualized in the graphical user interface image 1500 indicating the upcoming ten days starting from the selected date of 18^{th} of May and a corresponding attribution to either a safe time window 1516 or the animal protection time window 1512. A user may then know from the graphical user interface image 1500 when application of the chemical product in the overlap zone 1330 is allowed and when it is not allowed. Moreover, an agricultural device may be controlled such that agricultural processing is performed during the safe time window 1516.

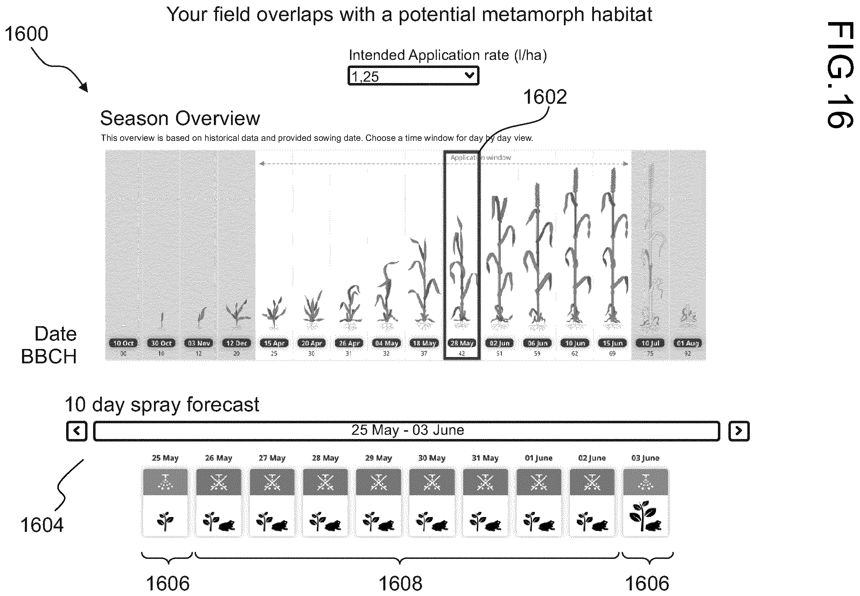

Fig. 16 shows a subsequent graphical user interface image 1600 for providing information of when to apply the chemical product selected in the graphical user interface image 1300 on the second crop field 1328 that has an overlap zone 1330 with the habitat 1322.

In contrast to the graphical user interface image 1500, in the graphical user interface image 1600, the 25^{th} of May has been selected. The corresponding growth stage of the winter wheat is indicated by the box 1602 enclosing the schematically depicted growth stage of winter wheat for the 28^{th} of May. As can be obtained from the ten day spray forecast 1604, only the 25^{th} of May as well as the 3^{rd} of June belong to the safe time window 1606 whereas the days in between these dates are within the animal protection time window 1608.

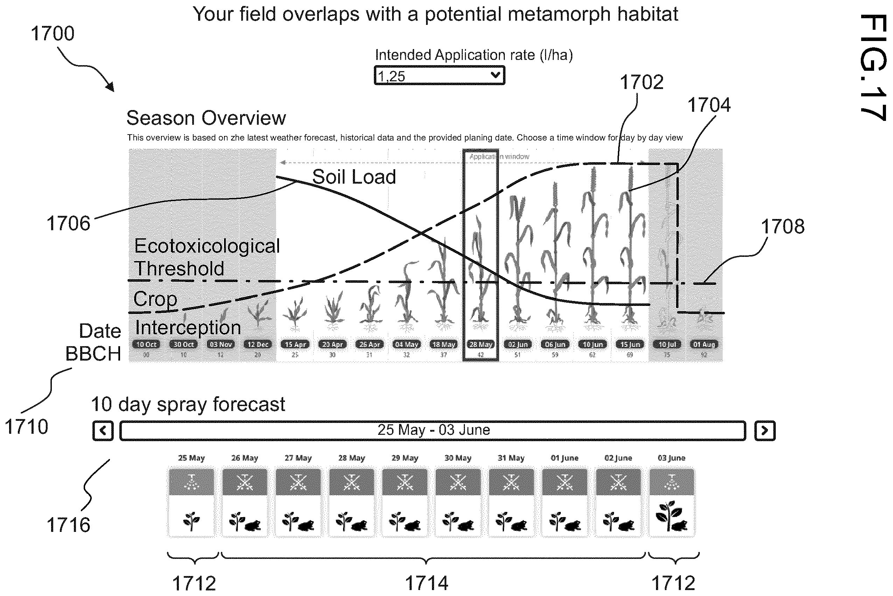

Fig. 17 shows a subsequent graphical user interface image 1700 that shows the same features as the graphical user interface image 1600. In addition, the graphical user interface image 1700 shows a dashed line 1702 indicating the crop interception associated with each of the schematically depicted growth stages 1704 of winter wheat. Moreover, the graphical user interface image 1700 shows a solid line 1706 representing the soil load associated with the respective crop interception 1702. The dashed-dotted line 1708 indicates the ecotoxicological threshold. The ecotoxicological threshold 1708 is typically set by regulatory authorities approving plant protection products. The soil load 1706 represents the exposure reaching the soil. The exposure may be determined based on the determined interception 1702 using the simulated BBCH stage 1710. The interception 1702 and the soil load 1706 may be compared to the ecotoxicological threshold 1708 to determine with even more accuracy whether a selected date lies within the safe time window 1712 or within the animal protection time window 1714. If the soil load 1706 is below the ecotoxicological threshold 1708, application of the chemical product can be performed without risking to negatively affect the animal species present in the overlap zone. Since for the selected date of 25^{th} of May, the selected soil load 1706 is above the ecotoxicological threshold 1708 is only below the ecotoxicological threshold 1708 starting from the 2^{nd} of June, as for the graphical user interface image 1600, only the 25^{th} of May and the 3^{rd} of June are attributed to the safe time window 1712 and the days in between of the ten day spray forecast 1716 are attributed to the animal protection time window 1714.

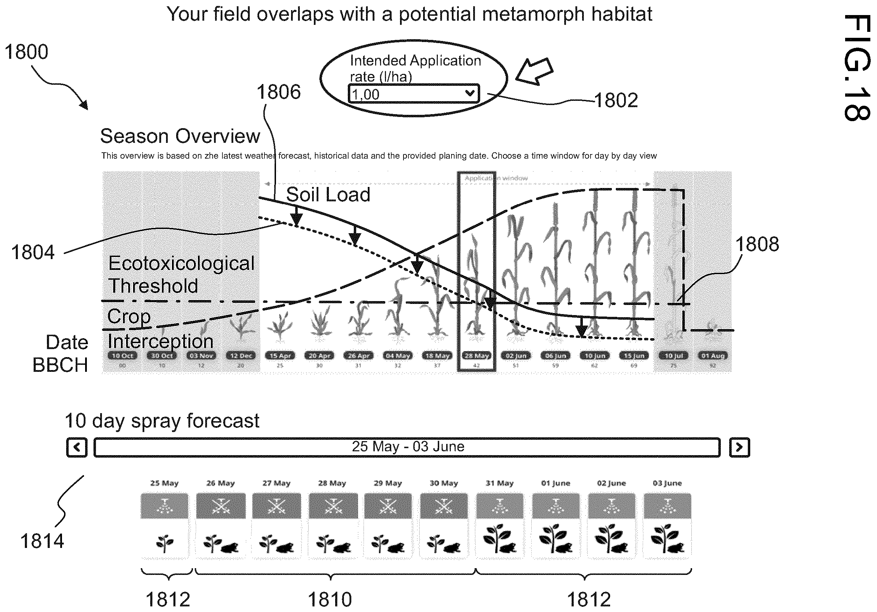

Fig. 18 shows a subsequent graphical user interface image 1800. In contrast to the graphical user interface image 1700, the intended application rate 1802 has been lowered in the input mask 1306 of the graphical user interface image 1300 from 1.25 I/ha to 1.00 I/ha. As a consequence, the soil load is lowered from solid line 1806 (also shown as solid line 1706 in graphical user interface image 1700) to the dashed line 1804. This results in the dashed line 1804 intersecting with the ecotoxicological threshold represented by dashed-dotted-line 1808 already at the 28^{th} of May and thus earlier as in the graphical user interface image 1700.

Consequently, since the soil load 1804 is below the ecotoxicological threshold 1808 starting from the 28^{th} of May, the duration of the animal protection time window 1810 is reduced in comparison to animal protection time window 1714 of the graphical user interface image 1700. Accordingly, the safe time window 1812 is longer during the ten day spray forecast 1814 as for the graphical user interface image 1700. Thus, to reduce a duration of the animal protection time window 1810, it is possible to reduce the concentration or the applied amount of a chemical substance.

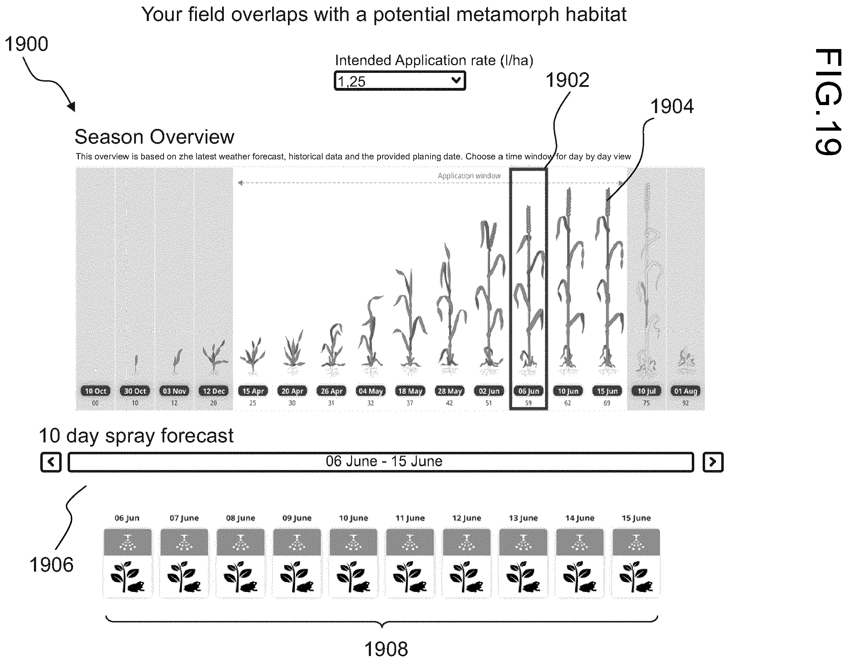

Fig. 19 shows a further subsequent graphical user interface image 1900 in which a different date has been selected, namely, the 6^{th} of June as indicated by the box 1902 enclosing a schematically depicted growth stage 1904 of winter wheat. As can be obtained from the ten day spray forecast 1907 starting with the 6^{th} of June, each of these ten days lies within the safe time window 1908 such that the chemical product can be applied without restrictions.

Other variations to the disclosed embodiments can be understood and effected by those skilled in the art in practicing the claimed invention, from a study of the drawings, the disclosure, and the appended claims.

In the claims, the words "comprising" and "including" do not exclude other elements or steps, and the indefinite article "a" or "an" does not exclude a plurality.

A single unit or device may fulfil the functions of several items recited in the claims. The mere fact that certain measures are recited in mutually different dependent claims does not indicate that a combination of these measures cannot be used to advantage.

A computer program product may be stored/distributed on a suitable medium, such as an optical storage medium or a solid-state medium, supplied together with or as part of other hardware, but may also be distributed in other forms, such as via the Internet or other wired or wireless telecommunication systems.

Any units described herein may be processing units that are part of a classical computing system. Processing units may include a general-purpose processor and may also include a field programmable gate array (FPGA), an application specific integrated circuit (ASIC), or any other specialized circuit. Any memory may be a physical system memory, which may be volatile, non-volatile, or some combination of the two. The term "memory" may include any computer-readable storage media such as a non-volatile mass storage. If the computing system is distributed, the processing and/or memory capability may be distributed as well. The computing system may include multiple structures as "executable components". The term "executable component" is a structure well understood in the field of computing as being a structure that can be software, hardware, or a combination thereof. For instance, when implemented in software, one of ordinary skill in the art would understand that the structure of an executable component may include software objects, routines, methods, and so forth, that may be executed on the computing system. This may include both an executable component in the heap of a computing system, or on computer-readable storage media. The structure of the executable component may exist on a computer-readable medium such that, when interpreted by one or more processors of a computing system, e.g., by a processor thread, the computing system is caused to perform a function. Such structure may be computer readable directly by the processors, for instance, as is the case if the executable component were binary, or it may be structured to be inter-pretable and/or compiled, for instance, whether in a single stage or in multiple stages, so as to generate such binary that is directly interpretable by the processors. In other instances, structures may be hard coded or hardwired logic gates, that are implemented exclusively or near-exclusively in hardware, such as within a field programmable gate array (FPGA), an application specific integrated circuit (ASIC), or any other specialized circuit. Accordingly, the term "executable component" is a term for a structure that is well understood by those of ordinary skill in the art of computing, whether implemented in software, hardware, or a combination. Any embodiments herein are described with reference to acts that are performed by one or more processing units of the computing system. If such acts are implemented in software, one or more processors direct the operation of the computing system in response to having executed computer-executable instructions that constitute an executable component. The computing system may also contain communication channels that allow the computing system to communicate with other computing systems over, for example, network. A "network" is defined as one or more data links that enable the transport of electronic data between computing systems and/or modules and/or other electronic devices. When information is transferred or provided over a network or another communications connection, for example, either hardwired, wireless, or a combination of hardwired or wireless, to a computing system, the computing system properly views the connection as a transmission medium. Transmission media can include a network and/or data links which can be used to carry desired program code means in the form of computer-executable instructions or data structures and which can be accessed by a general-purpose or specialpurpose computing system or combinations. While not all computing systems require a user interface, in some embodiments, the computing system includes a user interface system for use in interfacing with a user. User interfaces act as input or output mechanism to users for instance via displays.

Those skilled in the art will appreciate that at least parts of the invention may be practiced in network computing environments with many types of computing system configurations, including, personal computers, desktop computers, laptop computers, message processors, hand-held devices, multi-processor systems, microprocessor-based or programmable consumer electronics, network PCs, minicomputers, main-frame computers, mobile telephones, PDAs, pagers, routers, switches, datacentres, wearables, such as glasses, and the like. The invention may also be practiced in distributed system environments where local and remote computing system, which are linked, for example, either by hardwired data links, wireless data links, or by a combination of hardwired and wireless data links, through a network, both perform tasks. In a distributed system environment, program modules may be located in both local and remote memory storage devices.

Those skilled in the art will also appreciate that at least parts of the invention may be practiced in a cloud computing environment. Cloud computing environments may be distributed, although this is not required. When distributed, cloud computing environments may be distributed internationally within an organization and/or have components possessed across multiple organizations. In this description and the following claims, "cloud computing" is defined as a model for enabling on-demand network access to a shared pool of configurable computing resources, e.g., networks, servers, storage, applications, and services. The definition of "cloud computing" is not limited to any of the other numerous advantages that can be obtained from such a model when deployed. The computing systems of the figures include various components or functional blocks that may implement the various embodiments disclosed herein as explained. The various components or functional blocks may be implemented on a local computing system or may be implemented on a distributed computing system that includes elements resident in the cloud or that implement aspects of cloud computing. The various components or functional blocks may be implemented as software, hardware, or a combination of software and hardware. The computing systems shown in the figures may include more or less than the components illustrated in the figures and some of the components may be combined as circumstances warrant.

Any reference signs in the claims should not be construed as limiting the scope.

The present invention relates to protecting an animal species present in an animal protection zone. A life stage of the animal species is determined based on an animal life-cycle model, which is configured for simulating a life-cycle of the animal species. An animal protection time window is determined based on the life stage of the animal species during which no agricultural processing, which may negatively affect the animal species is to be performed in the animal protection zone in order to protect the animal species. Furthermore, an overlap zone is determined based on a spatial overlap between an agricultural zone and the animal protection zone, and a safe time window for an agricultural processing in the overlap zone is determined. The safe time window has no temporal overlap with the animal protection time window. This allows providing a safe time window in which the animal species is protected in the overlap zone.

## Claims

1. Agricultural system (100) for protecting an animal species (402) present in an animal protection zone (202), the agricultural system (100) being configured for
- obtaining or generating agricultural zone data indicative of an agricultural zone (200) in which agricultural processing is planned,
- obtaining or generating protection zone data indicative of the animal protection zone (202) that is associated with the animal species (402) present therein,
- providing an animal life-cycle model which is configured for simulating a life-cycle of the animal species (402),
- determining a life stage of the animal species (402) based on the animal life-cycle model,
- determining an animal protection time window (302) based on the life stage of the animal species (402) during which no agricultural processing which may negatively affect the animal species (402) is to be performed in the animal protection zone (202),
- determining an overlap zone (210) as a spatial overlap between the agricultural zone (200) and the animal protection zone (202) based on the agricultural zone data and protection zone data, and
- determining a safe time window (300) for an agricultural processing within the overlap zone (210) in dependence on the animal protection time window (302), the safe time window (300) having no temporal overlap with the animal protection time window (302).

2. Agricultural system (100) according to claim 1, wherein the animal life-cycle model is configured for simulating the life-cycle of the animal species (402) based on weather data.

3. Agricultural system (100) according to claim 2, further configured for obtaining the weather data based on geographical information of the agricultural zone (200), or based on geographical information of the animal protection zone (202), or based on the geographical location information of the agricultural zone (200) and the geographical information of the animal protection zone (202).

4. Agricultural system (100) according to at least one of the preceding claims, configured for determining a likelihood of a presence of the animal species (402) in the overlap zone (210) based on the simulated life-cycle of the animal species (402) and for determining the safe time window (300) based on the determined likelihood of the presence of the animal species (402) in the overlap zone (210).

5. Agricultural system (100) according to at least one of the claims 1 to 4, further configured for providing or generating a safe time window signal based on the determined safe time window (300), wherein the safe time window signal is a control signal or includes a control signal usable for controlling an agricultural device (50), the control signal being configured for controlling the agricultural device (50) to perform agricultural processing within the overlap zone (210) during the safe time window (300).

6. Agricultural system (100) according to claim 5, further comprising an agricultural device (50) configured for performing the agricultural processing in the agricultural zone (200) based on the safe time window signal.

7. Agricultural system (100) according to at least one of the claims 1 to 6, further configured for adapting the agricultural processing in the agricultural zone (200) such that no agricultural processing is performed in the overlap zone (210) during the animal protection time window (302).

8. Agricultural system (100) according to at least one of the claims 1 to 7, configured for determining a growth stage of a crop growing or to be grown in the agricultural zone (200) based on an agricultural growth model and for determining the animal protection time window (302) in dependence on the determined growth stage of the crop.

9. Agricultural system (100) according to at least one of the claims 1 to 8, configured for determining a crop interception indicative of an ability of a chemical product to reach a soil surface within the overlap zone, wherein the agricultural system is configured for determining the animal protection time window (302) in dependence on the determined crop interception.

10. Agricultural system (100) according to at least one of claims 1 to 9, configured for determining a crop interception for the crop based on a growth stage of the crop using an agricultural growth model and for determining a soil load using the determined crop interception , wherein for determining the animal protection time window (302), the agricultural system (100) is configured to evaluate the determined soil load in relation to a predefined ecotoxicological threshold.

11. Agricultural system (100) according to at least one of the preceding claims, configured for determining a growth stage of a crop growing or to be grown in the agricultural zone (200) based on an agricultural growth model, wherein the agricultural system (100) is configured for performing the agricultural processing in the overlap zone (210) during the safe time window (300) in dependence on the growth stage of the crop,
or
wherein the agricultural system (100) is configured for determining an agricultural processing time window (304) based on the growth stage of the crop, the agricultural processing time window (304) indicating a time range in which agricultural processing is to be performed in the agricultural zone (200).

12. Computer-implemented method (1200) for protecting an animal species present in an animal protection zone, the computer-implemented method comprising the steps of
- obtaining or generating agricultural zone data indicative of an agricultural zone in which agricultural processing is planned,
- obtaining or generating protection zone data indicative of the animal protection zone that is associated with the animal species present therein,
- providing an animal life-cycle model which is configured for simulating a life-cycle of the animal species (402),
- determining a life stage of the animal species based on the animal life-cycle model (S1),
- determining an animal protection time window based on the life stage of the animal species during which no agricultural processing which may negatively affect the animal species is to be performed in the animal protection zone (S2),
- determining an overlap zone as a spatial overlap between the agricultural zone and the animal protection zone based on the agricultural zone data and protection zone data (S3), and
- determining a safe time window for an agricultural processing in the overlap zone in dependence on the animal protection time window, the safe time window having no temporal overlap with the animal protection time window (S4).

13. Computer-implemented method (1200) according to claim 12, including one or more of the steps:
- simulating the life-cycle of the animal species by the animal life-cycle model based on weather data,
- obtaining or generating the weather data based on geographical information of the agricultural zone, or based on a geographical information of the animal protection zone, or based on the geographical location information of the agricultural zone and the geographical information of the animal protection zone,
- determining a likelihood of a presence of the animal species in the overlap zone based on the simulated life-cycle of the animal species,
- determining the safe time window based on the determined likelihood of the presence of the animal species in the agricultural zone,
- providing a safe time window signal based on the determined safe time window,
- providing a safe time window signal usable for controlling an agricultural device such as a robot to perform the agricultural processing in the agricultural zone,
- causing an agricultural device such as a robot to perform the agricultural processing in the agricultural zone based on the safe time window signal,
- performing the agricultural processing in the overlap zone during the safe time window,
- adapting the agricultural processing in the agricultural zone such that no agricultural processing is performed in the overlap zone during the animal protection time window,
- obtaining or receiving or generating a growth stage of a crop growing or to be grown in the agricultural zone,
- performing the agricultural processing in the overlap zone during the safe time window in dependence on the obtained growth stage of the crops,
- determining an agricultural processing time window based on the growth stage of the crop, the agricultural processing time window indicating a time range in which agricultural processing is to be performed in the agricultural zone.

14. Computer program product for protecting an animal species, wherein the computer program product comprises program code means for causing a processor (16) to carry out the computer-implemented method according to claim 12 or 13, when the computer program product is run on the processor (16).

15. Computer-readable medium (18) having stored the computer program product of claim 14.

## Patentansprüche

1. Landwirtschaftliches System (100) zum Schutz einer in einer Tierschutzzone (202) vorkommenden Tierart (402), wobei das landwirtschaftliche System (100) gestaltet ist zum
- Erhalten oder Erzeugen von Landwirtschaftszonendaten, die für eine Landwirtschaftszone (200) bezeichnend sind, in der landwirtschaftliche Verarbeitung geplant ist;
- Erhalten oder Erzeugen von Schutzzonendaten, die für die Tierschutzzone (202) bezeichnend sind, die mit der darin vorkommenden Tierart (402) verbunden ist,
- Bereitstellen eines Tierlebenszyklusmodells, das dafür gestaltet ist, einen Lebenszyklus der Tierart (402) zu simulieren;
- Bestimmen einer Lebensphase der Tierart (402) auf der Grundlage des Tierlebenszyklusmodells;
- Bestimmen eines Tierschutz-Zeitfensters (302) auf der Grundlage der Lebensphase der Tierart (402), in dem keine landwirtschaftliche Verarbeitung, die eine ungünstige Auswirkung auf die Tierart (402) haben kann, in der Tierschutzzone (202) durchgeführt werden darf;
- Bestimmen einer Überlappungszone (210) als eine räumliche Überlappung zwischen der Landwirtschaftszone (200) und der Tierschutzzone (202) auf der Grundlage der Landwirtschaftszonendaten und der Schutzzonendaten und
- Bestimmen eines sicheren Zeitfensters (300) für eine landwirtschaftliche Verarbeitung in der Überlappungszone (210) abhängig von dem Tierschutz-Zeitfenster (302), wobei das sichere Zeitfenster (300) keine zeitliche Überlappung mit dem Tierschutz-Zeitfenster (302) aufweist.

2. Landwirtschaftliches System (100) nach Anspruch 1, wobei das Tierlebenszyklusmodell dafür gestaltet ist, den Lebenszyklus der Tierart (402) auf der Grundlage von Wetterdaten zu simulieren.

3. Landwirtschaftliches System (100) nach Anspruch 2, ferner gestaltet zum Erhalten der Wetterdaten auf der Grundlage von geografischen Informationen der Landwirtschaftszone (200) oder auf der Grundlage von geografischen Informationen der Tierschutzzone (202) oder auf der Grundlage der geografischen Standortinformationen der Landwirtschaftszone (200) und der geografischen Informationen der Tierschutzzone (202).

4. Landwirtschaftliches System (100) nach wenigstens einem der vorstehenden Ansprüche, gestaltet zum Bestimmen einer Wahrscheinlichkeit eines Vorhandenseins der Tierart (402) in der Überlappungszone (210) auf der Grundlage des simulierten Lebenszyklus der Tierart (402) und zum Bestimmen des sicheren Zeitfensters (300) auf der Grundlage der bestimmten Wahrscheinlichkeit des Vorhandenseins der Tierart (402) in der Überlappungszone (210).

5. Landwirtschaftliches System (100) nach wenigstens einem der Ansprüche 1 bis 4, ferner gestaltet zum Bereitstellen oder Erzeugen eines sicheres-Zeitfenster-Signals auf der Grundlage des bestimmten sicheren Zeitfensters (300), wobei das sicheres-Zeitfenster-Signal ein Steuersignal ist oder ein Steuersignal enthält, das zum Steuern einer landwirtschaftlichen Vorrichtung (50) verwendbar ist, wobei das Steuersignal dafür gestaltet ist, die landwirtschaftliche Vorrichtung (50) zu steuern, um landwirtschaftliche Verarbeitung in der Überlappungszone (210) während des sicheren Zeitfensters (300) durchzuführen.

6. Landwirtschaftliches System (100) nach Anspruch 5, ferner umfassend eine landwirtschaftliche Vorrichtung (50), gestaltet zum Durchführen der landwirtschaftlichen Verarbeitung in der Landwirtschaftszone (200) auf der Grundlage des sicheres-Zeitfenster-Signals.

7. Landwirtschaftliches System (100) nach wenigstens einem der Ansprüche 1 bis 6, ferner gestaltet zum Anpassen der landwirtschaftlichen Verarbeitung in der Landwirtschaftszone (200), so dass während des Tierschutz-Zeitfensters (302) keine landwirtschaftliche Verarbeitung in der Überlappungszone (210) durchgeführt wird.

8. Landwirtschaftliches System (100) nach wenigstens einem der Ansprüche 1 bis 7, gestaltet zum Bestimmen eines Wachstumsstadiums einer in der Landwirtschaftszone (200) wachsenden oder anzubauenden Kulturpflanze auf der Grundlage eines landwirtschaftlichen Wachstumsmodells und zum Bestimmen des Tierschutz-Zeitfensters (302) abhängig von dem bestimmten Wachstumsstadium der Kulturpflanze.

9. Landwirtschaftliches System (100) nach wenigstens einem der Ansprüche 1 bis 8, gestaltet zum Bestimmen einer Kulturpflanzen-Interzeption, die eine Fähigkeit eines chemischen Produkts angibt, eine Bodenoberfläche in der Überlappungszone zu erreichen, wobei das landwirtschaftliche System dafür gestaltet ist, das Tierschutz-Zeitfenster (302) abhängig von der bestimmten Kulturpflanzen-Interzeption zu bestimmen.

10. Landwirtschaftliches System (100) nach wenigstens einem der Ansprüche 1 bis 9, gestaltet zum Bestimmen einer Kulturpflanzen-Interzeption für die Kulturpflanze auf der Grundlage einer Wachstumsstufe der Kulturpflanze unter Verwendung eines landwirtschaftlichen Wachstumsmodells und zum Bestimmen einer Bodenbelastung unter Verwendung der bestimmten Kulturpflanzen-Interzeption, wobei zum Bestimmen des Tierschutz-Zeitfensters (302) das landwirtschaftliche System (100) dafür gestaltet ist, die bestimmte Bodenbelastung bezogen auf einen vordefinierten ökotoxikologischen Schwellenwert zu bewerten.

11. Landwirtschaftliches System (100) nach wenigstens einem der vorstehenden Ansprüche, gestaltet zum Bestimmen einer Wachstumsstufe einer Kulturpflanze, die in der Landwirtschaftszone (200) wächst oder angebaut werden soll, auf der Grundlage eines landwirtschaftlichen Wachstumsmodells, wobei das landwirtschaftliche System (100) dafür gestaltet ist, die landwirtschaftliche Verarbeitung in der Überlappungszone (210) während des sicheren Zeitfensters (300) abhängig von der Wachstumsstufe der Kulturpflanze durchzuführen,
oder
wobei das landwirtschaftliche System (100) dafür gestaltet ist, ein landwirtschaftliches Verarbeitungszeitfenster (304) auf der Grundlage der Wachstumsstufe der Kulturpflanze zu bestimmen, wobei das landwirtschaftliche Verarbeitungszeitfenster (304) einen Zeitbereich angibt, in dem landwirtschaftliche Verarbeitung in der Landwirtschaftszone (200) durchzuführen ist.

12. Computerimplementiertes Verfahren (1200) zum Schützen einer in einer Tierschutzzone vorkommenden Tierart, wobei das computerimplementierte Verfahren die Schritte umfasst
- Erhalten oder Erzeugen von Landwirtschaftszonendaten, die für eine Landwirtschaftszone bezeichnend sind, in der landwirtschaftliche Verarbeitung geplant ist,
- Erhalten oder Erzeugen von Schutzzonendaten, die für die Tierschutzzone bezeichnend sind, die mit der darin vorkommenden Tierart verbunden ist,
- Bereitstellen eines Tierlebenszyklusmodells, das dafür gestaltet ist, einen Lebenszyklus der Tierart (402) zu simulieren;
- Bestimmen einer Lebensphase der Tierart auf der Grundlage des Tierlebenszyklusmodells (S1);
- Bestimmen eines Tierschutz-Zeitfensters auf der Grundlage der Lebensphase der Tierart, in dem keine landwirtschaftliche Verarbeitung, die eine ungünstige Auswirkung auf die Tierart haben kann, in der Tierschutzzone durchgeführt werden darf (S2);
- Bestimmen einer Überlappungszone als eine räumliche Überlappung zwischen der Landwirtschaftszone und der Tierschutzzone auf der Grundlage der Landwirtschaftszonendaten und der Schutzzonendaten (S3), und
- Bestimmen eines sicheren Zeitfensters für eine landwirtschaftliche Verarbeitung in der Überlappungszone abhängig von dem Tierschutz-Zeitfenster, wobei das sichere Zeitfenster keine zeitliche Überlappung mit dem Tierschutz-Zeitfenster aufweist (S4).

13. Computerimplementiertes Verfahren (1200) nach Anspruch 12, das einen oder mehrere der Schritte einschließt:
- Simulieren des Lebenszyklus der Tierart nach dem Tierlebenszyklusmodell auf der Grundlage von Wetterdaten;
- Erhalten oder Erzeugen der Wetterdaten auf der Grundlage geografischer Informationen der Landwirtschaftszone oder auf der Grundlage geografischer Informationen der Tierschutzzone oder auf der Grundlage der geografischen Standortinformationen der Landwirtschaftszone und der geografischen Informationen der Tierschutzzone;
- Bestimmen einer Wahrscheinlichkeit eines Vorhandenseins der Tierart in der Überlappungszone auf der Grundlage des simulierten Lebenszyklus der Tierart;
- Bestimmen des sicheren Zeitfensters auf der Grundlage der bestimmten Wahrscheinlichkeit des Vorhandenseins der Tierart in der Landwirtschaftszone,
- Bereitstellen eines sicheres-Zeitfenster-Signals auf der Grundlage des bestimmten sicheren Zeitfensters,
- Bereitstellen eines sicheres-Zeitfenster-Signals, das zum Steuern einer landwirtschaftlichen Vorrichtung, wie z.B. eines Roboters, zur Durchführung der landwirtschaftlichen Verarbeitung in der Landwirtschaftszone verwendet werden kann;
- Veranlassen einer landwirtschaftlichen Vorrichtung, wie z.B. eines Roboters, die landwirtschaftliche Verarbeitung in der Landwirtschaftszone auf der Grundlage des sicheres-Zeitfenster-Signals durchzuführen,
- Durchführen der landwirtschaftlichen Verarbeitung in der Überlappungszone während des sicheren Zeitfensters;
- Anpassen der landwirtschaftlichen Verarbeitung in der Landwirtschaftszone, so dass während des Tierschutz-Zeitfensters keine landwirtschaftliche Verarbeitung in der Überlappungszone durchgeführt wird;
- Erhalten oder Empfangen oder Erzeugen einer Wachstumsstufe einer in der Landwirtschaftszone wachsenden oder anzubauenden Kulturpflanze;
- Durchführen der landwirtschaftlichen Verarbeitung in der Überlappungszone während des sicheren Zeitfensters abhängig von der erhaltenen Wachstumsstufe der Kulturpflanzen;
- Bestimmen eines Zeitfensters für die landwirtschaftliche Verarbeitung auf der Grundlage der Wachstumsstufe der Kulturpflanze, wobei das Zeitfenster für die landwirtschaftliche Verarbeitung einen Zeitbereich angibt, in dem die landwirtschaftliche Verarbeitung in der Landwirtschaftszone durchzuführen ist.

14. Computerprogrammprodukt zum Schützen einer Tierspezies, wobei das Computerprogrammprodukt Programmcodemittel zum Bewirken umfasst, dass ein Prozessor (16) das computerimplementierte Verfahren nach Anspruch 12 oder 13 ausführt, wenn das Computerprogrammprodukt auf dem Prozessor (16) ausgeführt wird.

15. Computerlesbares Medium (18), auf dem das Computerprogrammprodukt nach Anspruch 14 gespeichert ist.

## Revendications

1. Système agricole (100) pour la protection d'une espèce animale (402) présente dans une zone de protection animale (202), le système agricole (100) étant conçu pour
- obtenir ou générer des données de zone agricole indicatives d'une zone agricole (200) dans laquelle un traitement agricole est planifié,
- obtenir ou générer des données de zone de protection indicatives de la zone de protection animale (202) qui est associée à l'espèce animale (402) présente en son sein,
- fournir un modèle de cycle de vie animal qui est conçu pour simuler un cycle de vie de l'espèce animale (402),
- déterminer un stade de vie de l'espèce animale (402) sur la base du modèle de cycle de vie animal,
- déterminer une fenêtre temporelle de protection animale (302) sur la base du stade de vie de l'espèce animale (402) pendant laquelle aucun traitement agricole qui peut affecter négativement l'espèce animale (402) ne doit être mis en œuvre dans la zone de protection animale (202),
- déterminer une zone de chevauchement (210) en tant que chevauchement spatial entre la zone agricole (200) et la zone de protection animale (202) sur la base des données de zone agricole et des données de zone de protection, et
- déterminer une fenêtre temporelle sûre (300) pour un traitement agricole dans la zone de chevauchement (210) en fonction de la fenêtre temporelle de protection animale (302), la fenêtre temporelle sûre (300) ne présentant pas de chevauchement temporel avec la fenêtre temporelle de protection animale (302).

2. Système agricole (100) selon la revendication 1, le modèle de cycle de vie animal étant conçu pour simuler le cycle de vie de l'espèce animale (402) sur la base de données météorologiques.

3. Système agricole (100) selon la revendication 2, en outre conçu pour obtenir les données météorologiques sur la base d'informations géographiques de la zone agricole (200) ou sur la base d'informations géographiques de la zone de protection animale (202) ou sur la base des informations d'emplacement géographique de la zone agricole (200) et des informations géographiques de la zone de protection animale (202).

4. Système agricole (100) selon au moins l'une des revendications précédentes, conçu pour déterminer une probabilité d'une présence de l'espèce animale (402) dans la zone de chevauchement (210) sur la base du cycle de vie simulé de l'espèce animale (402) et pour déterminer la fenêtre temporelle sûre (300) sur la base de la probabilité déterminée de la présence de l'espèce animale (402) dans la zone de chevauchement (210).

5. Système agricole (100) selon au moins l'une des revendications 1 à 4, en outre conçu pour fournir ou générer un signal de fenêtre temporelle sûre sur la base de la fenêtre temporelle sûre (300) déterminée, le signal de fenêtre temporelle sûre étant un signal de commande ou comprenant un signal de commande utilisable pour commander un dispositif agricole (50), le signal de commande étant configuré pour commander le dispositif agricole (50) afin qu'il mette en œuvre un traitement agricole dans la zone de chevauchement (210) pendant la fenêtre temporelle sûre (300).

6. Système agricole (100) selon la revendication 5, comprenant en outre un dispositif agricole (50) conçu pour mettre en œuvre le traitement agricole dans la zone agricole (200) sur la base du signal de fenêtre temporelle sûre.

7. Système agricole (100) selon au moins l'une des revendications 1 à 6, en outre conçu pour adapter le traitement agricole dans la zone agricole (200) de telle sorte qu'aucun traitement agricole n'est mis en œuvre dans la zone de chevauchement (210) pendant la fenêtre temporelle de protection animale (302).

8. Système agricole (100) selon au moins l'une des revendications 1 à 7, conçu pour déterminer un stade de croissance d'une culture en croissance ou à faire croître dans la zone agricole (200) sur la base d'un modèle de croissance agricole et pour déterminer la fenêtre temporelle de protection animale (302) en fonction du stade de croissance déterminé de la culture.

9. Système agricole (100) selon au moins l'une des revendications 1 à 8, conçu pour déterminer une interception de culture indicative d'une aptitude d'un produit chimique à atteindre une surface de sol dans la zone de chevauchement, le système agricole étant conçu pour déterminer la fenêtre temporelle de protection animale (302) en fonction de l'interception de culture déterminée.

10. Système agricole (100) selon au moins l'une des revendications 1 à 9, conçu pour déterminer une interception de culture pour la culture sur la base d'un stade de croissance de la culture à l'aide d'un modèle de croissance agricole et pour déterminer une charge de sol à l'aide de l'interception de culture déterminée, dans lequel, pour déterminer la fenêtre temporelle de protection animale (302), le système agricole (100) est conçu pour évaluer la charge de sol déterminée en relation avec un seuil écotoxicologique prédéfini.

11. Système agricole (100) selon au moins l'une des revendications précédentes, conçu pour déterminer un stade de croissance d'une culture en croissance ou à faire croître dans la zone agricole (200) sur la base d'un modèle de croissance agricole, le système agricole (100) étant conçu pour mettre en œuvre le traitement agricole dans la zone de chevauchement (210) pendant la fenêtre temporelle sûre (300) en fonction du stade de croissance de la culture
ou
le système agricole (100) étant conçu pour déterminer une fenêtre temporelle de traitement agricole (304) sur la base du stade de croissance de la culture, la fenêtre temporelle de traitement agricole (304) indiquant l'intervalle temporel pendant lequel le traitement agricole doit être mis en œuvre dans la zone agricole (200).

12. Procédé mis en œuvre par un ordinateur (1200) pour la protection d'une espèce animale présente dans une zone de protection animale, le procédé mis en œuvre par un ordinateur comprenant les étapes consistant à
- obtenir ou générer des données de zone agricole indicatives d'une zone agricole dans laquelle un traitement agricole est planifié,
- obtenir ou générer des données de zone de protection indicatives de la zone de protection animale qui est associée à l'espèce animale présente en son sein,
- fournir un modèle de cycle de vie animal qui est conçu pour simuler un cycle de vie de l'espèce animale (402),
- déterminer un stade de vie de l'espèce animale sur la base du modèle de cycle de vie animal (S1),
- déterminer une fenêtre temporelle de protection animale sur la base du stade de vie de l'espèce animale pendant laquelle aucun traitement agricole qui peut affecter négativement l'espèce animale ne doit être mis en œuvre dans la zone de protection animale (S2),
- déterminer une zone de chevauchement en tant que chevauchement spatial entre la zone agricole et la zone de protection animale sur la base des données de zone agricole et des données de zone de protection (S3) et
- déterminer une fenêtre temporelle sûre pour un traitement agricole dans la zone de chevauchement en fonction de la fenêtre temporelle de protection animale, la fenêtre temporelle sûre ne présentant pas de chevauchement temporel avec la fenêtre temporelle de protection animale (S4).

13. Procédé mis en œuvre par un ordinateur (1200) selon la revendication 12, comprenant l'une ou plusieurs des étapes consistant à :
- simuler le cycle de vie de l'espèce animale par le modèle de cycle de vie animal sur la base de données météorologiques,
- obtenir ou générer les données météorologiques sur la base d'informations géographiques de la zone agricole ou sur la base d'informations géographiques de la zone de protection animale ou sur la base des informations d'emplacement géographique de la zone agricole et des informations géographiques de la zone de protection animale,
- déterminer une probabilité d'une présence de l'espèce animale dans la zone de chevauchement sur la base du cycle de vie simulé de l'espèce animale,
- déterminer la fenêtre temporelle sûre sur la base de la probabilité déterminée de la présence de l'espèce animale dans la zone agricole,
- fournir un signal de fenêtre temporelle sûre sur la base de la fenêtre temporelle sûre déterminée,
- fournir un signal de fenêtre temporelle sûre utilisable pour commander un dispositif agricole, tel qu'un robot, afin qu'il mette en œuvre le traitement agricole dans la zone agricole,
- amener un dispositif agricole, tel qu'un robot, à mettre en œuvre le traitement agricole dans la zone agricole sur la base du signal de fenêtre temporelle sûre,
- mettre en œuvre le traitement agricole dans la zone de chevauchement pendant la fenêtre temporelle sûre,
- adapter le traitement agricole dans la zone agricole de telle sorte qu'aucun traitement agricole n'est mis en œuvre dans la zone de chevauchement pendant la fenêtre temporelle de protection animale,
- obtenir ou recevoir ou générer un stade de croissance d'une culture en croissance ou à faire croître dans la zone agricole,
- mettre en œuvre le traitement agricole dans la zone de chevauchement pendant la fenêtre temporelle sûre en fonction du stade de croissance obtenu de la culture,
- déterminer une fenêtre temporelle de traitement agricole sur la base du stade de croissance de la culture, la fenêtre temporelle de traitement agricole indiquant un intervalle temporel pendant lequel le traitement agricole doit être mis en œuvre dans la zone agricole.

14. Produit programme informatique pour la protection d'une espèce animale, le produit programme informatique comprenant des moyens de code de programme destinés à amener un processeur (16) à effectuer le procédé mis en œuvre par un ordinateur selon la revendication 12 ou 13 lorsque le produit programme informatique est exécuté sur le processeur (16).

15. Support lisible par ordinateur (18) sur lequel est enregistré le produit programme informatique de la revendication 14.
